(19) Europäisches Patentamt / European Patent Office / Office européen des brevets

(11) **EP 2 902 449 B1**

(12) **EUROPEAN PATENT SPECIFICATION**

(45) Date of publication and mention
of the grant of the patent:
**19.09.2018 Bulletin 2018/38**

(21) Application number: **13840232.6**

(22) Date of filing: **28.01.2013**

(51) Int Cl.:
*C08L 101/00* (2006.01)     *C09J 9/02* (2006.01)
*C09J 11/04* (2006.01)     *C09J 163/00* (2006.01)
*C09J 201/02* (2006.01)     *H01B 1/00* (2006.01)
*H01B 1/22* (2006.01)     *C08K 3/08* (2006.01)

(86) International application number:
**PCT/JP2013/051792**

(87) International publication number:
**WO 2014/050156 (03.04.2014 Gazette 2014/14)**

(54) **CONDUCTIVE COMPOSITION AND CONDUCTIVE MOLDED BODY USING SAME**

LEITFÄHIGE ZUSAMMENSETZUNG UND LEITFÄHIGER FORMKÖRPER DARAUS

COMPOSITION CONDUCTRICE ET CORPS MOULÉ CONDUCTEUR UTILISANT LADITE COMPOSITION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.09.2012 JP 2012215008
16.11.2012 JP 2012252058**

(43) Date of publication of application:
**05.08.2015 Bulletin 2015/32**

(73) Proprietor: **Mitsuboshi Belting Ltd.
Kobe-shi, Hyogo 653-0024 (JP)**

(72) Inventors:
• **ISEDA Taisuke
Kobe-shi
Hyogo 653-0024 (JP)**
• **TAKIGUCHI Motohiro
Kobe-shi
Hyogo 653-0024 (JP)**
• **KAWAHARA Kazutomo
Kobe-shi
Hyogo 653-0024 (JP)**
• **OCHI Koshi
Kobe-shi
Hyogo 653-0024 (JP)**
• **IWAMOTO Masahiro
Kobe-shi
Hyogo 653-0024 (JP)**

(74) Representative: **Hoffmann Eitle
Patent- und Rechtsanwälte PartmbB
Arabellastraße 30
81925 München (DE)**

(56) References cited:
EP-A1- 2 455 947     EP-A1- 2 827 341
JP-A- H0 967 553     JP-A- H1 166 953
JP-A- S6 431 874     JP-A- 2005 251 542
JP-A- 2006 111 903     JP-A- 2011 044 509
JP-A- 2011 044 509     JP-A- 2011 100 573
JP-A- 2011 238 596     JP-A- 2011 238 596
JP-A- 2012 036 481     US-A1- 2005 194 577

**EP 2 902 449 B1**

**Description**

TECHNICAL FIELD

The present invention relates to a conductive composition useful for forming conductive adhesives, electrodes and a molded body (conductive molded body) containing a conductive region (conductive adhesive layer, electrode, wiring, etc.) formed of the conductive composition.

BACKGROUND ART

Conductive compositions (conductive pastes) containing a conductive metal powder (conductive filler) such as a silver paste have been used for forming electrodes or circuits of electronic components. Of these, in the conductive paste containing a thermoplastic or thermosetting resin, usually, conductivity is realized by the contact of conductive fillers one another resulting from the shrinkage of the used resin, and also close contact or adhesiveness to a base material is secured by the presence of the resin. Therefore, in the conductive paste containing such a binder, in order to obtain sufficient conductivity, it is important to increase the contact area between the conductive metal powders. From this point of view, as the conductive metal powder, an attempt of using a metal flake (a flaky metal powder) has been made.

For example, Patent Document 1 discloses a conductive paste containing a flaky silver powder and an organic resin. The document exemplifies, as the organic resin, a wide range of organic resins such as polyester resins, modified polyester resins (urethane-modified polyester resins etc.), polyether-urethane resins, polycarbonate-urethane resins, vinyl chloride-vinyl acetate copolymers, epoxy resins, phenolic resins, acrylic resins, polyamideimides, nitrocellulose, cellulose acetate butyrate, and cellulose acetate propionate. In particular, polyester resins and urethane-modified polyester resins are used in Examples from the viewpoints of bending resistance.

Moreover, Patent Document 2 discloses a flaky silver powder in which the average particle diameter and the BET specific surface area have a specific relationship. In this document, as the resin used in the conductive paste, there are exemplified epoxy resins, acrylic resins, polyester resins, polyimide resins, polyurethane resins, phenoxy resins, and silicone resins, and polyester resins are used in Examples.

Patent Document 3 discloses a conductive silver paste comprising epoxy resin, flake-shaped silver powders having an average particle diameter of 0.5 to 50 μm, and spherical silver powders, each having its surface coated with organic matter, having an average particle diameter of not more than 1 μm. According to this document, a conductive film is formed by printing or applying the conductive silver paste on a surface of a base material, followed by drying, and then thermosetting the epoxy resin.

Patent Document 4 relates to the problem of forming an electrode, in which the electrode width can be narrowed more and the resistance can be lowered, and which has sufficient adhesion even in a narrow adhesion area, and also has high reliability due to superior heat resistance and water resistance, in an electrode or electric wiring, especially, a collector electrode of a solar cell. The solution to this problem proposed in this document is a conductive ink composition including conductive particles; a thermosetting resin composition; and an organic system vehicle containing a curing agent and a solvent. The conductive particles include: nano-silver particles whose average particle diameter is ≥1 nm and <100 nm; and flake-like copper particles whose average flake diameter is ≥0.1 μm and ≤3 μm. Also, according to this disclosure, the conductive particles include the flake-like copper particles more than the nano-silver particles in terms of mass ratio.

Patent Document 5 relates to the provision of an adhesive having high heat conductivity and high electric conductivity by including a conductive spherical silver powder having a maximum particle size and average particle size of not more than a specific value in an epoxy resin or a polyimide resin of an organic resin at a specific rate. The solution proposed in this document is the use of a spherical silver powder having a maximum particle size of not more than 1 μm and an average particle size not more than 0.2 μm. The adhesive is composed of conductive powder: 50 to 90 wt.% and an organic resin: 4 to 36 wt.%.

In such a situation, a further improvement in conductivity and adhesiveness has been desired.

BACKGROUND ART DOCUMENTS

PATENT DOCUMENTS

Patent Document 1: JP-A-2008-171828
Patent Document 2: JP-A-2012-92442
Patent Document 3: US 20050194577 A1

2

Patent Document 4: JP2011044509 (A)
Patent Document 5: JP H11-066953

SUMMARY OF THE INVENTION

PROBLEMS THAT THE INVENTION IS TO SOLVE

Accordingly, an object of the present invention is to provide a conductive composition which can realize excellent conductivity even when a resin component is contained and a molded body having a conductive region formed of the conductive composition.

Another object of the present invention is to provide a conductive composition which can improve or enhance conductivity without impairing close contact or adhesiveness to a base material and a molded body having a conductive region formed of the conductive composition.

Yet another object of the present invention is to provide a conductive adhesive having excellent conductivity and heat radiation property and a molded body having a conjugated base material directly bonded by the conductive adhesive.

MEANS FOR SOLVING THE PROBLEMS

As a result of intensive studies for solving the above problems, the present inventors have found that by combining a metal nanoparticle and a specific resin component with a metal flake (flaky metal powder) in a conductive composition, high conductivity can be achieved, also excellent close contact or adhesiveness to a base material can be both achieved in spite of such high conductivity, and further, sufficient conductivity and heat radiation property (and furthermore, close contact) can be secured even in the conductive adhesive application where high heat radiation property is required. Thus, they have accomplished the present invention.

That is, the present invention is defined in the claims and provides a conductive composition containing a conductive metal powder and a resin component, in which the conductive metal powder contains a metal flake and a metal nanoparticle, wherein the metal nanoparticle has an average particle diameter (D50) of 4 to 100 nm, and the resin component contains an aromatic amine skeleton.

In the composition, the metal flake may have a crystalline structure in which a metal (or a metal crystal) grows (or crystal-grows) in a flake shape (or two-dimensionally). In particular, the metal flake may be a metal flake in which a value X represented by the following equation is 20% or less when diffraction integrated intensity values of a (111) plane and a (200) plane in X-ray diffraction are taken as $I_{111}$ and $I_{200}$, respectively.

$$X = [I_{200}/(I_{111}+I_{200})] \times 100 \ (\%).$$

As explained above, in the conductive composition according to the present invention, the metal nanoparticle has an average particle diameter (D50) of 4 to 100 nm. Further, the ratio of the metal flake to the metal nanoparticle may be, for example, as follows: the former/the latter (weight ratio) = approximately 99/1 to 30/70.

The resin component may be a thermosetting resin component. In the typical embodiment, the resin component may be composed of a thermosetting resin (or a thermosetting resin precursor) and a curing agent (or a crosslinking agent), and the thermosetting resin and/or the curing agent may be a thermosetting resin component containing an aromatic amine skeleton. In particular, in such a thermosetting resin composition, the curing agent may be composed of an aromatic amine-based curing agent.

In a more specific embodiment, the resin component may be an epoxy resin component containing an epoxy resin and a curing agent composed of an aromatic amine-based curing agent or a polyisocyanate resin component containing a polyisocyanate compound and a curing agent composed of an aromatic amine-based curing agent. In particular, the resin component may be an epoxy resin component containing an epoxy resin having an epoxy equivalent of 600 g/eq or less and a curing agent composed of an aromatic amine-based curing agent.

The aromatic amine-based curing agent is an aromatic amine-based curing agent having a structure in which an amino group is directly substituted on an aromatic ring.

In the composition according to the present invention, the ratio of the conductive metal powder to the resin component may be, for example, as follows: the former/the latter (weight ratio) = approximately 99/1 to 50/50. Typically, the ratio of the metal flake to the metal nanoparticle may be as follows: the former/the latter (weight ratio) = 97/3 to 35/65 and the ratio of the conductive metal powder to the resin component may be as follows: the former/the latter (weight ratio) = 97/3 to 70/30.

The conductive composition according to the present invention may be particularly a conductive adhesive (e.g., a die bond paste, etc.). In a more specific embodiment, it may be a conductive adhesive (a die bond paste) for bonding a metal base material [a lead frame, for example, a lead frame formed of a metal (copper, or a copper alloy), a lead frame formed of a metal and further plated] with a semiconductor base material (semiconductor chip, for example, a semiconductor base material, or a semiconductor chip in which a metal film is formed on a semiconductor base material). In this connection, in the case of the semiconductor chip on which a metal film is formed, it may be used as a conductive adhesive for bonding a lead frame with the metal film of the semiconductor chip.

The present invention further provides a molded body (conductive molded body) having at least a conductive region (or a conductive film) formed of the conductive composition described above. Such a molded body (an electric and electronic part, etc.) may be a molded body containing a conjugated base material composed of two base materials and a conductive adhesive that intervenes between the base materials and bonds the two base materials each other, in which the conductive adhesive is the conductive region formed of the conductive composition described above. Such a molded body may be composed of, for example, a base material (a lead frame, etc.) formed of a metal, another base material (a semiconductor chip, etc.) formed of a semiconductor, and the conductive composition described above that intervenes between these base materials and bonds them each other.

The present invention further provides a conductive molded body having at least a conductive region (or a conductive film) formed of a conductive composition as defined above containing a metal flake, a metal nanoparticle and a resin component, in which a value X represented by the following equation is 25% or less (particularly, 20% or less, and particularly preferably 10% or less) when diffraction integrated intensity values of a (111) plane and a (200) plane in X-ray diffraction of the conductive region are taken as $I_{111}$ and $I_{200}$, respectively.

$$X = [I_{200}/(I_{111}+I_{200})] \times 100 \ (\%).$$

The above-described conductive molded body may be, specifically, a molded body containing a conjugated base material composed of two base materials and a conductive adhesive that intervenes between the base materials and bonds the two base materials, in which the conductive adhesive is formed of a conductive composition containing a metal flake, a metal nanoparticle and a resin component, and in which the value X of the conductive adhesive is 25% or less (particularly, 20% or less, and particularly preferably 10% or less).

In the case where the conductive region or the conductive adhesive has a given thickness, the value X may be measured on the side (base material side) coming into contact with a base material or on a surface side. Depending on such a measuring portion, the value X slightly differs in some cases. But even in such a case, the value X preferably falls within the above-mentioned range.

In such a conductive molded body, the conductive composition is a conductive composition according to the invention containing a metal flake, a metal nanoparticle and a resin component (a resin component which may contain an aromatic amine skeleton). Usually, the metal flake may be a metal flake having a crystalline structure in which a metal (or a metal crystal) grows (or crystal-grows) in a flaky shape (or two-dimensionally). In particular, it may be a metal flake having the above-described value X of 25% or less (particularly, 20% or less, and particularly preferably 10% or less). That is, by using such the metal flake, surprisingly, also in a conductive molded body, a conductive region or a conductive adhesive maintain a crystal structure of the metal flake.

ADVANTAGE OF THE INVENTION

The conductive composition of the present invention can realize excellent conductivity although it contains a resin component as a binder. Moreover, such an improvement or enhancement in conductivity can be realized without impairing close contact or adhesiveness to a base material. Furthermore, since the conductive composition of the invention is excellent in conductivity and heat radiation property (thermal conductivity) and further sufficient close contact can be secured, it is particularly useful as a conductive adhesive.

MODE FOR CARRYING OUT THE INVENTION

<Conductive Composition>

The conductive composition of the present invention is composed of a specific conductive metal powder and a specific resin component as defined in the claims.

[Conductive Metal Powder]

The conductive metal powder contains at least a metal flake (a flaky metal powder, a plate-shaped metal powder, a scale-shaped metal powder) and a metal nanoparticle.

(Metal Flake)

Examples of the metal (metal atom) constituting the metal flake include transition metals (e.g., Group 4 metals of the periodic table such as titanium and zirconium; Group 5 metals of the periodic table such as vanadium and niobium; Group 6 metals of the periodic table such as molybdenum and tungsten; Group 7 metals of the periodic table such as manganese and rhenium; Groups 8 to 10 metals of the periodic table such as iron, nickel, cobalt, ruthenium, rhodium, palladium, iridium, and platinum; Group 11 metals of the periodic table such as copper, silver, and gold; etc.), Group 12 metals of the periodic table (e.g., zinc, cadmium, etc.), Group 13 metals of the periodic table (e.g., aluminum, gallium, indium, etc.), Group 14 metals of the periodic table (e.g., germanium, tin, lead, etc.), and Group 15 metals of the periodic table (e.g., antimony, bismuth, etc.). The metals may be used singly or in combination of two or more thereof.

Typical metals include Groups 8 to 10 metals of the periodic table (iron, nickel, rhodium, palladium, platinum, etc.), Group 11 metals of the periodic table (copper, silver, gold, etc.), Group 13 metals of the periodic table (aluminum etc.), and Group 14 metals of the periodic table (tin, etc.).

The metals may be metal simple substances and also in the form of metal alloys or compounds of metals and non-metals (e.g., metal oxides, metal hydroxides, metal sulfides, metal carbides, metal nitrides, metal borides, etc.). Usually, the metal is a metal simple substance or a metal alloy in many cases.

In particular, the metal is preferably a metal (e.g., a metal simple substance or a metal alloy) containing at least a noble metal (particularly, Group 11 metal of the periodic table) such as silver, and particularly a noble metal simple substance (e.g., silver simple substance, etc.).

These metal flakes can be used alone or in combination of two or more thereof.

The metal flake is not particularly limited and may be any of (i) a metal flake having a crystalline structure (crystalline structure 1) in which a metal (or a metal crystal) grows (or crystal-grows) in a flake shape (or two-dimensionally), (ii) a flaked (or flattened) product of a metal particle (or a spherical particle) having a crystalline structure (crystalline structure 2) in which a large number of crystallites are assembled.

Incidentally, the metal flake (i) mainly has the crystalline structure in which a crystal single substance is grown into a flaky metal but, in the metal flake (ii), usually, a metal fine particle (or an aggregate thereof) having the crystalline structure in which a large number of crystallites are assembled is flaked (or flattened), so that the flaked product also mainly has a crystalline structure in which a large number of crystallites are assembled. Moreover, in the metal flake (ii), since flaking is performed physically, fine irregularities are liable to form on the metal surface.

Although the metal flake (i) mainly having the crystalline structure 1 is suitable in view of resistance in crystal boundaries since the resistance is small as compared with the crystalline structure 2, the plate plane occupying most of the area of the flake among the crystal planes [e.g., mainly a (111) plane in the case of a face-centered cubic lattice, such as the case of a silver flake] has small surface energy and a metal bond at the interface is also hard to form, so that it is impossible to secure sufficient conductivity in some cases. On the other hand, in the metal flake (ii), resulting from the crystalline structure 2, the resistance at the grain boundaries increases as compared with the crystalline structure 1, but sintering at the metal flake interface is easy as compared with the case of the crystalline structure 1 probably resulting from the fine irregularities on the surface and thus a decrease in resistance owing to the metal bond can be also expected.

From such a point of view, the metal flake may be appropriately selected depending on the desired application and conductivity, but in the present invention, in particular, the metal flake (i) may be preferably used. Even in the case of the metal flake (i), high conductivity can be secured probably because sufficient contact between metal flakes can be secured by combining the metal flake with the metal nanoparticle and the resin component to be mentioned later. Furthermore, these components act synergistically and finally, it is possible to realize higher conductivity as compared with the case of using the metal flake (ii).

Incidentally, the degree of crystallinity in the metal flake can be estimated by using the diffraction intensity in X-ray diffraction as an index. In the powder X-ray diffraction method, in the metal flake having the crystalline structure 1 in which anisotropy (orientation) is imparted by crystal growth, diffraction for a flat plane or plate plane mainly appears at large intensity mainly corresponding to the (111) plane but, diffraction for a plane forming a thickness mainly corresponds to the (200) plane and its intensity appears extremely small. On the other hand, in the metal flake (ii) in which a large number of crystallites are assembled, anisotropy (orientation) is small and thus the difference in the diffraction intensity between the (111) plane and the (200) plane decreases. Therefore, the larger the intensity for the (111) plane is and the smaller the intensity for the (200) plane is, the larger the ratio of the crystalline structure 1 is. Specifically, when diffraction integrated intensity values of the (111) plane and the (200) plane in X-ray diffraction ($2\theta/\theta$ scan method)

are taken as $I_{111}$ and $I_{200}$, respectively, a metal flake in which a value X represented by the following equation is 25% or less (e.g., 0 to 22%), preferably 20% or less (e.g., 0 to 18%), more preferably 15% or less (e.g., 0 to 12%), particularly 10% or less (e.g., 0 to 9%) may be regarded as the metal flake having the crystalline structure 1 (i.e., the metal flake (i)).

$$X = [I_{200}/(I_{111}+I_{200})] \times 100\ (\%).$$

Incidentally, when such a metal flake is used, even after molding (e.g., after curing treatment of the conductive composition), in the conductive region or the conductive adhesive to be mentioned later, it is possible to efficiently obtain a conductive molded body maintaining the above value of X.

In the metal flake (ii), the value of X may be usually more than 25% (e.g., 27 to 40%), preferably approximately 30% or more (e.g., 32 to 40%), and may be usually approximately 27 to 40%.

As the metal flakes, commercially available products or those synthesized by conventional methods may be used. For example, as the metal flake (i), use can be made of those synthesized by using the production methods described in Japanese Patent No. 3,429,985, Japanese Patent No. 4,144,856, Japanese Patent No. 4,399,799, and JP-A-2009-144188, and the metal flakes described in these documents. The metal flake (ii) may be synthesized by using the methods described in Patent Documents 1 and 2 described above.

The average particle diameter of the metal flake may be, for example, approximately 0.1 to 20 $\mu$m, preferably 0.3 to 15 $\mu$m (e.g., 0.5 to 12 $\mu$m) and more preferably 0.7 to 10 $\mu$m (e.g., 0.8 to 7 $\mu$m), and may be usually approximately 1 to 10 $\mu$m. The average particle diameter of the metal flake can be measured, for example, by using a laser diffraction scattering particle size distribution measuring method. In such a measuring method, the average particle diameter (median particle diameter) is measured as a value based on volume.

The average thickness of the metal flake may be, for example, 5 to 1,000 nm, preferably 20 to 500 nm, further preferably 50 to 300 nm, and usually approximately 10 to 300 nm.

The aspect ratio of the metal flake (average particle diameter/average thickness) may be, for example, approximately 5 to 100, preferably 7 to 50, and more preferably 10 to 30.

The BET specific surface area of the metal flake can be selected from the range of approximately 0.3 to 7 $m^2$/g and may be, for example, approximately 0.5 to 6 $m^2$/g, preferably 1 to 5 $m^2$/g and more preferably 1.2 to 4 $m^2$/g, and may be usually approximately 1 to 5 $m^2$/g.

The tap density of the metal flake can be selected from the range of approximately 0.1 to 7 $g/cm^3$ (e.g., 0.2 to 6 $g/cm^3$) and may be, for example, approximately 0.3 to 5 $g/cm^3$, preferably 0.5 to 4.5 $g/cm^3$, more preferably 1 to 4 $g/cm^3$, and may be usually approximately 1.2 to 4 $g/cm^3$ (e.g., 1.5 to 3.5 $g/cm^3$).

(Metal Nanoparticle)

The metal flake is used in combination with the metal nanoparticle defined in the claims. By the combination of the metal flake with such a metal nanoparticle (and further a specific resin component), it is possible to realize high conductivity and close contact with good efficiency. The reason is not clear but, it is considered to be one reason that the contact area between metal flakes physically increases due to the intervention of the metal nanoparticle among the metal flakes or metal bonds are formed by sintering the metal nanoparticle. In particular, since such effects have a feature of supplementing the contact at the metal interface, the effects are frequently remarkable in the combination with the metal flake having the single crystalline structure as described above. However, even when the metal flake is simply combined with the metal nanoparticle, there are cases where sufficient contact cannot be secured, and high conductivity can be realized by further combining a specific resin component to be mentioned below.

The form of the metal nanoparticle may be sufficiently a non-flake shape and may be fibrous, but it may be usually spherical (or approximately spherical). The aspect ratio of the metal nanoparticle (spherical metal nanoparticle) may be, for example, 3 or less (e.g., 1 to 2.5), preferably 2 or less (e.g., 1 to 1.5).

The metal constituting the metal nanoparticle is the same as the metal as described in the section of the metal flake. In the metal flake and the metal nanoparticle, the constituent metal may be the same or different. The metal nanoparticle may be used singly or in combination of two or more thereof.

The average particle diameter (D50) of the metal nanoparticle is nano-size and is selected from the range of approximately 4 to 100 nm. The average particle diameter can be measured by using an electron microscope (transmission electron microscope, scanning electron microscope, etc.) or a laser diffraction scattering particle size distribution measuring method.

Incidentally, as the metal nanoparticle, use can be made of commercially available products or those synthesized by conventional methods. Examples of the commercially available products include Silvest C-34, Silvest H-1, and Silvest E-20 manufactured by Tokuriki Chemical Research Co., Ltd., ST-M, SPH02J manufactured by Mitsui Mining and Smelting Co., Ltd., Superfine Silver Powder-1, Silver Nanoparticle Dry Powder-1, and Silver Nanoparticle Dry Powder-2 manufactured by DOWA Electronics Co., Ltd., G-13, G-35, and GS-36 manufactured by DOWA Hightech Co., Ltd., and AgC-101, AgC-111, AgC-114, AgC-141, AgC-152, AgC-153, and AgC-154 manufactured by Fukuda Metal Foil & Powder Co., Ltd..

Moreover, as methods for producing the metal nanoparticle, there may be mentioned methods described in JP-A-2005-281781, JP-A-2005-298921, JP-A-2006-124787, JP-A-2006-152344, JP-A-2007-146271, JP-A-2007-321215, JP-A-2008-223101, JP-A-2009-30084, JP-A-2009-62598, JP-A-2009-74171, JP-A-2009-120940, JP-A-2010-202943, and JP-A-2010-229544.

Incidentally, the ratio (proportion) of the average particle diameter of the metal flake to the average particle diameter of the metal nanoparticle may be as follows: for example, the former/the latter = approximately 2/1 to 5000/1 (e.g., 3/1 to 3000/1), preferably 4/1 to 2000/1 (e.g., 5/1 to 1500/1) and more preferably 10/1 to 1000/1.

The ratio of the metal flake to the metal nanoparticle (spherical metal nanoparticle etc.) can be selected from the range of the former/the latter (weight ratio) = 99/1 to 5/95 (e.g., 98/2 to 10/90) and may be, for example, approximately 97/3 to 15/85 (e.g., 96/4 to 20/80), preferably 95/5 to 25/75 (e.g., 93/7 to 27/73), more preferably 90/10 to 30/70 (e.g., 88/12 to 35/65), and particularly 85/15 to 40/60 (e.g., 80/20 to 45/55), and may be usually approximately 80/20 to 40/60. In particular, the ratio of the metal flake to the metal nanoparticle may be as follows: the former/the latter (weight ratio) = approximately 99/1 to 10/90 (e.g., 98.5/1.5 to 15/85), preferably 98/2 to 20/80 (e.g., 97.5/2.5 to 30/70), more preferably 97/3 to 35/65 (e.g., 96/4 to 40/60), and may be usually approximately 99/1 to 30/70.

[Resin Component]

In the present invention, the resin component constituting the conductive composition has an aromatic amine skeleton. By combining the metal nanoparticle and the resin component having an aromatic amine skeleton with the metal flake, high conductivity can be realized and sufficient close contact to the base material can be secured. The reason is not clear but, there are cases where the resin having an aromatic amine skeleton promotes the contact and sintering (formation of metal bonds) between the metal flakes, the metal flake and the metal nanoparticle, and further the metal nanoparticles in some way, and also it is also assumed that good compatibility of the resin structure having a rigid aromatic amine skeleton with a rigid metal network structure formed in the combination with the metal flake the metal nanoparticle.

The resin component may be any of a thermoplastic resin (or a thermoplastic resin component, for example, a condensation resin such as a polyamide resin and a polyester resin; an addition polymerization resin such as a (meth)acrylic resin), and a thermosetting resin component but, in the present invention, a thermosetting resin component may be preferably used. Examples of the thermosetting resin (or thermosetting resin component) include epoxy resins, phenolic resins, amino resins, polyurethane resins (polyisocyanate compounds or polyisocyanate resins), (meth)acrylic resins, and polyimide resins.

The resin component contains an aromatic amine skeleton according to the embodiment of the resin. The aromatic amines of the invention have an amino group directly substituted on the aromatic ring. Incidentally, the aromatic amine skeleton may have a free amino group, which may be contained in a resin monomer. For example, in the case where the resin component is a thermoplastic resin, a resin containing an aromatic amine as a polymerization component (or a monomer) [e.g., a polyamide resin containing a diamine component including an aromatic diamine (an aromatic amine-based curing agent exemplified in the section of the epoxy resin component to be mentioned later) as a polymerization component; and an addition polymerization resin (a (meth)acrylic resin, etc.) containing a radical polymerizable monomer (e.g., 2-ethylaminophenyl (meth)acrylate, 4-(benzoylamino)phenyl (meth)acrylate, etc.) having an aromatic amine skeleton as a polymerization component].

On the other hand, in the case where the resin component is a thermosetting resin component, there may be mentioned a thermosetting resin containing an aromatic amine as a polymerization component (or a monomer) (e.g., a glycidylamine type aromatic epoxy resin, an aniline resin, etc.) or a thermosetting resin component containing an aromatic amine as a curing agent (or a crosslinking agent), a curing accelerator, or an initiator [e.g., a thermosetting resin component containing a thermosetting resin (e.g., an epoxy resin, a phenolic resin, a polyisocyanate compound, etc.) and a curing agent (or a curing accelerator) composed of an aromatic amine-based curing agent (e.g., a curing agent for epoxy resins, phenolic resins, or polyisocyanate compounds), etc.].

The resin component having an aromatic amine skeleton may be used singly or in combination of two or more thereof.

Incidentally, in the resin component, the ratio of the aromatic amine skeleton (e.g., the aromatic amine or the skeleton derived from the aromatic amine) may be, although it depends on the embodiment of the resin, for example, approximately 1% by weight or more (e.g., 2 to 100% by weight), preferably 3% by weight or more (e.g., 4 to 90% by weight) and more preferably 5% by weight or more (e.g., 7 to 80% by weight) of the entire resin component.

In particular, in the case where the resin component is a thermosetting resin component, the ratio of the aromatic amine skeleton to the entire thermosetting resin component (e.g., ratio of the aromatic amine-based curing agent) may be approximately 3% by weight or more (e.g., 4 to 100% by weight), preferably 5% by weight or more (e.g., 7 to 90% by weight) and more preferably 10% by weight or more (e.g., 15 to 80% by weight) of the entire resin component.

Typical resin component includes a thermosetting resin component composed of a thermosetting resin (or a thermosetting resin precursor) and a curing agent (or a crosslinking agent) wherein the thermosetting resin and/or the curing agent contain an aromatic amine skeleton. Among them, there is preferable a thermosetting resin component containing a thermosetting resin (e.g., an epoxy resin or a polyisocyanate compound) and a curing agent composed of an aromatic amine-based curing agent (a compound to be mentioned later). When the aromatic amine-based curing agent is used, it is possible to realize high conductivity more efficiently. The reason is not clear but, it is assumed that the balance of the sintering (formation of metal bonds) rate of the metal nanoparticle intervening between metal flakes and the curing rate due to the aromatic amine-based curing agent contributes the efficient decrease in resistance.

In such a case, the ratio of the aromatic amine-based curing agent may be, although it depends on the type of the thermosetting resin, for example, relative to 100 parts by weight of the thermosetting resin, approximately 0.1 to 800 parts by weight, preferably 0.5 to 500 parts by weight, more preferably 1 to 300 parts by weight (e.g., 2 to 200 parts by weight), and particularly 3 to 150 parts by weight (e.g., 5 to 100 parts by weight).

Hereinafter, as more specific examples, an epoxy resin component and a polyisocyanate resin component will be described in detail.

(Epoxy Resin Component)

A typical epoxy resin component includes an epoxy resin component containing an epoxy resin and a curing agent composed of an aromatic amine-based curing agent.

The epoxy resin is not particularly limited and may be any of mono functional epoxy resins [e.g., glycidyl ethers (e.g., aromatic monoglycidyl ethers such as phenyl glycidyl ether and o-phenylphenyl glycidyl ether), cycloalkenes oxides (e.g., 4-vinylepoxycyclohexane, epoxyhexahydrophthalic acid dialkyl esters, etc.), etc.] and polyfunctional epoxy resins, but usually can be formed by using at least a polyfunctional epoxy resin (or an epoxy compound).

The epoxy resins may be, for example, any of glycidyl ether type, glycidylamine type, glycidyl ester type, and alicyclic type (an epoxy resin having an epoxycycloalkane skeleton). Incidentally, in the polyfunctional epoxy resin, the number of epoxy groups may be sufficiently 2 or more and may be, for example, approximately 2 to 150 (e.g., 2 to 120), preferably 2 to 100 (e.g., 2 to 80), and more preferably 2 to 50 (e.g., 2 to 30).

Specific polyfunctional epoxy resins (epoxy resins having two or more epoxy groups) can be roughly classified into aliphatic epoxy resins (polyfunctional aliphatic epoxy resins), alicyclic epoxy resins [e.g., bifunctional alicyclic epoxy resins (e.g., 3,4-epoxycyclohexylmethyl-3,4-epoxy cyclohexanecarboxylate etc.), trifunctional or higher functional alicyclic epoxy resins (e.g., tri- to hexa-esters of alkane-tri- to hexa-ols with epoxycycloalkanecarboxylic acids, such as triester of 2,2-bis(hydroxymethyl)-1-butanol with 3,4-epoxycyclohexanecarboxylic acid, etc.), etc.], aromatic epoxy resins, and nitrogen-containing type epoxy resins (nitrogen-containing type polyfunctional epoxy resins, e.g., triglycidyl isocyanurate etc.).

Examples of the aliphatic epoxy resins include bifunctional aliphatic epoxy resins [e.g., aliphatic diglycidyl ethers (e.g., alkanediol diglycidyl ethers such as butanediol diglycidyl ether and neopentyl glycol diglycidyl ether; poly-$C_{2-4}$-alkanediol diglycidyl ethers such as polyethylene glycol diglycidyl ether and polypropylene glycol diglycidyl ether), diglycidyl ether type bifunctional aliphatic epoxy resins such as cyclohexanedimethanol diglycidyl ether; glycidyl ester type bifunctional aliphatic epoxy resins such as diglycidyl esters of hydrogenation products of aromatic dicarboxylic acids (e.g., tetrahydrophthalic acid, hexahydrophthalic acid, etc.) and dimer acid glycidyl esters], and trifunctional or higher functional aliphatic epoxy resins (e.g., tri- to hexa-glycidyl ethers of alkane-tri- to hexa-ols, such as trimethylolpropane triglycidyl ether, glycerin triglycidyl ether, and pentaerythritol tri- or tetra-glycidyl ether).

Examples of the aromatic epoxy resins include glycidyl ether type aromatic epoxy resins {e.g., polyglycidyloxyarenes [e.g., polyglycidyloxynaphthalenes such as diglycidyloxynaphthalenes (e.g., 1,5-di(glycidyloxy)naphthalene, 1,6-di(glycidyloxy) naphthalene, 2,6-di(glycidyloxy)naphthalene, 2,7-di(glycidyloxy)naphthalene, 2,7-di(2-methyl-2,3-epoxypropyloxy)naphthalene, etc.), and 2,2'-diglycidyloxybinaphthalene, etc.]; compounds in which polyglycidyloxyarenes (polyglycidyloxynaphthalenes exemplified in the above, etc.) are directly combined or linked via a linking group (e.g., an alkylene group such as a methylene group or an ethylene group, an alkylidene group, etc.) [e.g., poly(diglycidyloxynaphthyl)-$C_{1-10}$-alkanes such as 1,1'-methylenebis(2,7-diglycidyloxynaphthalene) and bis(2,7-diglycidyloxynaphthyl)methane]; tri- to octa-(glycidyloxyaryl)alkanes [e.g., tri- to hexa-(glycidyloxyphenyl)-$C_{1-10}$-alkanes such as 1,1,2,2-tetrakis(4-glycidyloxyphenyl)ethane and 1,1,1-tris(glycidyloxyphenyl)methane], bisphenol type epoxy resins; novolak type epoxy resins; diglycidyl aniline, etc.}, glycidyl ester type aromatic epoxy resins [diglycidyl esters of aromatic dicarboxylic acids (phthalic acid etc.), etc.]; and glycidylamine type aromatic epoxy resins [e.g., N,N-glycidylaniline; tetra- to octa-glycidylpolyamines such as tetraglycidyl diaminodiphenylmethane and tetraglycidyl-meta-xylylenediamine; triglycidyl-para-aminophenol; N,N-diglycidyl-4-glycidyloxyaniline (or N,N-bis(2,3-epoxypropyl)-4-(2,3-epoxypropoxy)aniline), etc.].

As the bisphenol type epoxy resins, there may be mentioned diglycidyl ethers of bisphenols or adducts of alkylene oxides (e.g., $C_{2-4}$ alkylene oxides such as ethylene oxide and propylene oxide). Examples of the bisphenols include biphenol; bis(hydroxyphenyl)-$C_{1-10}$-alkanes such as bisphenol A, bisphenol B, bisphenol E, and bisphenol F; bis(hydroxy-$C_{1-10}$-alkylphenyl)-$C_{1-10}$-alkanes such as 2,2-bis(3-methyl-4-hydroxyphenyl) propane and bisphenol G; bis(hydroxy-$C_{6-10}$-arylphenyl)-$C_{1-10}$-alkanes such as bisphenol PH; bis(hydroxyphenyl)-$C_{5-10}$-cycloalkanes such as bisphenol Z and bisphenol TMC; bisphenol AP, bisphenol BP; bisphenol AF; bisphenol S; bisphenol M; and bisphenol P. In the alkylene oxide adducts of bisphenols, the number of added moles of alkylene oxide per 1 mole of the hydroxyl groups of the bisphenols may be, for example, approximately 1 mol or more (e.g., 1 to 20 mol), preferably 1 to 15 mol, and more preferably 1 to 10 mol.

As the novolak type epoxy resin, there may be mentioned glycidyl etherified compounds of novolak resins using a phenolic compound as a polymerization component. In such novolak type epoxy resins, as the phenolic compound (compound having a phenolic hydroxyl group), there may be mentioned phenols [e.g., phenol; substituted phenols such as alkylphenols (e.g., $C_{1-20}$-alkylphenols, preferably $C_{1-12}$-alkylphenol, more preferably $C_{1-4}$-alkylphenols, such as cresol, ethylphenol, s-butylphenol, t-butylphenol, 1,1,3,3-tetramethylbutylphenol, decylphenol, and dodecylphenol), and aralkyl-phenols (e.g., $C_{6-10}$-aryl-$C_{1-10}$-alkylphenols such as 1,1-dimethyl-1-phenylmethylphenol)], naphthols (e.g., naphthol etc.), and bisphenols (e.g., biphenol, bisphenols exemplified in the above, such as bisphenol A). These phenolic compounds may constitute a novolak resin singly or in combination of two or more thereof.

The novolak resin may be a modified novolak resin. For example, the novolak resin may be a novolak resin having a non-phenolic compound skeleton [e.g., an araliphatic skeleton (e.g., $C_{6-10}$-arene-di-$C_{1-4}$-alkylene skeleton such as a xylylene skeleton), an alicyclic skeleton (e.g., a cross-linked alicyclic hydrocarbon skeleton such as a dicyclopentadiene skeleton), etc.] or may be a halogenated (e.g., brominated) novolak resin.

Examples of typical novolak type epoxy resins include novolak type epoxy resins using a phenolic compound as a polymerization component [e.g., phenol novolak type epoxy resins, alkylphenol novolak type epoxy resins (e.g., cresol novolak type epoxy resins etc.), naphthol novolak type epoxy resins, bisphenol novolak type epoxy resins (e.g., bisphenol A novolak type epoxy resins, bisphenol F novolak type epoxy resin, etc.), etc.], and modified novolak type epoxy resins using a phenolic compound as a polymerization component [e.g., modified novolak type epoxy resins using the phenolic compound as a polymerization component, such as aralkyl novolak type epoxy resins (e.g., xylylene skeleton-containing phenol novolak resins etc.), dicyclopentadiene skeleton-containing novolak type epoxy resins (e.g., dicyclopentadiene skeleton-containing phenol novolak type epoxy resins), biphenyl skeleton-containing novolak type epoxy resins (e.g., biphenyl skeleton-containing phenol novolak type epoxy resins), and brominated novolak type epoxy resins (e.g., brominated phenol novolak type epoxy resins)].

Incidentally, the number average molecular weight of the novolak type epoxy resin may be, for example, approximately 1,000 to 1,000,000, preferably 5,000 to 500,000, and more preferably 10,000 to 100,000.

The epoxy resins may be used singly or in combination of two or more thereof.

The epoxy equivalent of the epoxy resin is not particularly limited and can be selected from the range of approximately 800 g/eq or less (e.g., 50 to 750 g/eq), and may be, for example, approximately 700 g/eq or less (e.g., 70 to 650 g/eq), preferably 600 g/eq or less (e.g., 80 to 550 g/eq), and particularly 500 g/eq or less (e.g., 100 to 450 g/eq).

In the case where a polyfunctional epoxy resin is combined with a monofunctional epoxy resin, the ratio thereof can be selected from the range of the former/the latter (weight ratio) = approximately 99.9/0.1 to 30/70 (e.g., 99.5/0.5 to 40/60) and may be, for example, approximately 99/1 to 50/50, preferably 97/3 to 60/40, and more preferably 95/5 to 70/30.

The epoxy resin component contains a curing agent (epoxy resin curing agent) composed of an aromatic amine-based curing agent in addition to the epoxy resin as a main component (and the other epoxy resin as needed).

The aromatic amines of the invention have an amino group directly substituted on the aromatic ring. Examples of the aromatic amine-based curing agent include polyaminoarenes (e.g., diaminoarenes, preferably diamino-$C_{6-10}$ arenes, such as para-phenylenediamine and meta-phenylenediamine), polyamino-alkylarenes (e.g., diamino-alkylarenes, preferably diamino-mono- to tri-$C_{1-4}$-alkyl-$C_{6-10}$-arenes, such as diethyltoluenediamine), poly(aminoaryl)alkanes (e.g., di(aminoaryl)alkanes, preferably di(amino-$C_{6-10}$-aryl)-$C_{1-6}$-alkanes, such as diaminodiphenylmethane), poly(amino-alkylaryl)alkanes (e.g., di(amino-alkylaryl)alkanes, preferably di(amino-$C_{1-4}$-alkyl-$C_{6-10}$-aryl)-$C_{1-6}$-alkanes, such as 4,4'-methylenebis(2-ethyl-6-methylaniline)), bis(aminoarylalkyl)arenes (e.g., bis(amino-$C_{6-10}$-aryl-$C_{1-10}$-alkyl)-$C_{6-10}$-arenes such as 1,3-bis[2-(4-aminophenyl)-2-propyl]]benzene and 1,4-bis[2-(4-aminophenyl)-2-propyl)]benzene, etc.), di(aminoaryl) ethers (e.g., di(amino-$C_{6-12}$-aryl) ethers, preferably di(amino-$C_{6-10}$-aryl) ethers, such as diaminodiphenyl ether, etc.), di(aminoaryloxy)arenes (e.g., di(amino-$C_{6-12}$-aryloxy)-$C_{6-12}$-arenes, preferably di(amino-$C_{6-10}$-aryloxy)-$C_{6-10}$-arenes, such as 1,3-bis(3-aminophenoxy)benzene), di(aminoaryl) sulfones (e.g., di(amino-$C_{6-12}$-aryl) sulfones, and preferably di(amino-$C_{6-10}$-aryl) sulfones, such as diaminodiphenyl sulfone, etc.). The aromatic amine-based curing agents may be used singly or in combination of two or more thereof.

As mentioned above, the aromatic amines of the invention have an amino group directly substituted on the aromatic ring [e.g., poly(aminoaryl)alkanes, di(aminoaryl) ethers, etc.].

Incidentally, as long as the curing agent contains an aromatic amine-based curing agent, it may be combined with the other curing agent. Examples of the other curing agent include non-aromatic amine-based curing agents {e.g., aliphatic amine-based curing agents (e.g., (poly)alkylenepolyamines such as ethylenediamine, hexamethylenediamine, diethylenetriamine, triethylenetetramine, tetraethylenepentamine, and diethylaminopropylamine, etc.), alicyclic amine-based curing agents (e.g., monocyclic aliphatic polyamines such as menthenediamine, isophoronediamine, bis(4-amino-3-methylcyclohexyl)methane, and 3,9-bis(3-aminopropyl)-2,4,8,10-tetraoxaspiro[5.5] undecane; cross-linked cyclic polyamines such as norbornanediamine; etc), imidazole-based curing agents [imidazoles (e.g., alkylimidazoles such as 2-methylimidazole, 2-phenylimidazole, 2-heptadecylimidazole, and 2-ethyl-4-methylimidazole; arylimidazoles such as 2-phenylimidazole, 2-phenyl-4-methylimidazole, 2-phenyl-4-methyl-5-hydroxymethylimidazole, and 1-benzyl-2-phenylimidazole), salts of imidazoles (e.g., organic salts such as formate salts, phenol salts, and phenol novolak salts; salts such as carbonate salts), reaction products (or adducts) of epoxy compounds (e.g., polyepoxy compounds such as diglycidyl ether of bisphenol A) with imidazoles, etc.], etc.}, phenol resin-based curing agents (e.g., novolak resins exemplified in the section of the novolak type epoxy resins, such as phenol novolak resin and cresol novolak resin, etc.), acid anhydride-based curing agents (e.g., aliphatic carboxylic acid anhydrides such as dodecenylsuccinic anhydride and adipic anhydride; alicyclic carboxylic acid anhydrides such as tetrahydrophthalic anhydride, methyltetrahydrophthalic anhydride, hexahydrophthalic anhydride, methylhexahydrophthalic anhydride, methylhimic anhydride, and methylcyclohexenedicarboxylic acid anhydride; aromatic carboxylic acid anhydrides such as phthalic anhydride, trimellitic anhydride, pyromellitic anhydride, and benzophenonetetracarboxylic acid anhydride), polyaminoamide-based curing agents, polymercaptan-based curing agents, and latent curing agents (boron trifluoride-amine complexes, dicyandiamide, carboxylic acid hydrazide, etc.). These curing agents may be used singly or in combination of two or more thereof. Incidentally, the curing agent may also act as a curing accelerator in some cases.

In the case where the aromatic amine-based curing agent is combined with the other curing agent, the ratio thereof can be selected from the range of the former/the latter (weight ratio) = approximately 99.9/0.1 to 30/70 (e.g., 99.5/0.5 to 40/60), and may be, for example, approximately 99/1 to 50/50, preferably 98/2 to 70/30, and more preferably 97/3 to 80/20.

The ratio of the curing agent (or the aromatic amine-based curing agent) depends on the type of the curing agent and also the combination of the epoxy resin with the curing agent but may be, for example, relative to 100 parts by weight of the epoxy resin, approximately 0.1 to 500 parts by weight, preferably 1 to 300 parts by weight, and more preferably 2 to 200 parts by weight (e.g., 3 to 100 parts by weight) and may be usually approximately 4 to 80 parts by weight (e.g., 5 to 60 parts by weight).

Depending on the type of the curing agent, the ratio of the curing agent can be appropriately selected according to the epoxy equivalent of the epoxy resin. For example, relative to 1 equivalent of the epoxy group of the epoxy resin, the ratio may be, for example, such that the functional group (the amino group etc.) of the curing agent becomes, for example, 0.1 to 4.0 equivalents, preferably 0.3 to 2.0 equivalents, and more preferably 0.5 to 1.5 equivalents.

Moreover, the epoxy resin component may contain a curing accelerator. The curing accelerator is not particularly limited and there may be mentioned conventional curing accelerators for epoxy resins, and examples thereof include phosphines (e.g., ethylphosphine, propylphosphine, phenylphosphine, triphenylphosphine, trialkylphosphine, etc.), amines (e.g., secondary to tertiary amines such as piperidine, triethylamine, benzyldimethylamine, triethanolamine, dimethylaminoethanol, triethylenediamine, tris(dimethylaminomethyl)phenol, and N,N-dimethylpiperazine, or salts thereof, etc.). Furthermore, depending on the combination, the curing agents exemplified above (e.g., imidazoles etc.) can be also used as a curing accelerator. The curing accelerator may be used singly or in combination of two or more thereof.

The ratio of the curing accelerator is not particularly limited and may be, although it depends on the combination with the epoxy resin and the curing agent, for example, relative to 100 parts by weight of the epoxy resin, approximately 0.01 to 100 parts by weight, preferably 0.05 to 80 parts by weight and more preferably 0.1 to 50 parts by weight and may be usually approximately 0.5 to 30 parts by weight (e.g., 1 to 25 parts by weight).

(Polyisocyanate Resin Component)

A typical polyisocyanate resin component includes a polyisocyanate resin component containing a polyisocyanate compound and a curing agent composed of an aromatic amine-based curing agent.

Examples of the polyisocyanate compound include, besides polyisocyanates, modified product of the polyisocyanates {e.g., blocked isocyanates [polyisocyanates blocked with a blocking agent (e.g., a pyrazole compound such as pyrazole, an alkylpyrazole (3-methylpyrazole, etc.), a halopyrazole (3-chloropyrazole, etc.); an alcohol; a phenol; an imide; an imidazole; etc.)], oligomers (dimers, trimers, etc.), carbodiimide bodies, biuret bodies, allophanate bodies, uretdione bodies, etc.}, and isocyanate-terminated prepolymers in which a polyisocyanate and a polyhydroxy compound [an alkanediol (ethylene glycol, propylene glycol, etc.), a di- to tetra-alkanediol (diethylene glycol, etc.), a polyether polyol, a polyester polyol, a trifunctional or higher functional polyol (glycerin, trimethylolpropane, pentaerythritol, etc.), etc.] or a polyamine compound are reacted.

The polyisocyanates can be roughly classified into, for example, aliphatic polyisocyanates, alicyclic polyisocyanates, araliphatic polyisocyanates, and aromatic polyisocyanates.

Examples of the aliphatic polyisocyanates include aliphatic diisocyanates {e.g., alkane diisocyanates [e.g., $C_{2-20}$ alkane-diisocyanates, preferably $C_{4-12}$ alkane-diisocyanates, such as 1,6-hexamethylene diisocyanate, 2,2,4-trimethylhexamethylene diisocyanate, 2,4,4-trimethylhexamethylene diisocyanate, and lysine diisocyanate etc.), etc.], etc.}, and aliphatic polyisocyanates having three or more isocyanate groups (e.g., triisocyanates such as 1,3,6-hexamethylene triisocyanate, 1,4,8-triisocyanatooctane, etc.).

Examples of the alicyclic polyisocyanates include alicyclic diisocyanates {cycloalkanes diisocyanates (e.g., $C_{5-8}$-cycloalkane-diisocyanates such as methyl-2,4-cyclohexane diisocyanate, methyl-2,6-cyclohexane diisocyanate, etc.), isocyanatoalkyl cycloalkane isocyanates (e.g., isocyanato-$C_{1-6}$-alkyl-$C_{5-10}$-cycloalkane-isocyanates such as isophorone diisocyanate), di(isocyanatoalkyl)cycloalkanes [e.g., di(isocyanato-$C_{1-6}$-alkyl)-$C_{5-10}$-cycloalkanes such as 1,4-di(isocyanatomethyl)cyclohexane], di(isocyanatocycloalkyl) alkanes [e.g., bis(isocyanato-$C_{5-10}$-cycloalkyl)-$C_{1-10}$-alkanes such as 4,4'-methylene-bis-cyclohexyl isocyanate, etc.], polycycloalkane diisocyanates (norbornane diisocyanate etc.), etc.}, and alicyclic polyisocyanates having three or more isocyanate groups (e.g., triisocyanates such as 1,3,5-triisocyanatocyclohexane, etc.).

Examples of the araliphatic polyisocyanates include di(isocyanatoalkyl)arenes [e.g., bis(isocyanato-$C_{1-6}$-alkyl)-$C_{6-12}$-arenes such as xylylene diisocyanate and tetramethylxylylene diisocyanate, etc.].

Examples of aromatic polyisocyanates include aromatic diisocyanates {e.g., arene diisocyanates [e.g., $C_{6-12}$-arene diisocyanates such as o-, m-, or p-phenylene diisocyanate, chlorophenylene diisocyanate, tolylene diisocyanate, and naphthalene diisocyanate, etc.], di(isocyanatoaryl)alkanes [e.g., diphenylmethane diisocyanate (MDI) (2,4'-diphenylmethane diisocyanate, 4,4'-diphenylmethane diisocyanate, etc.), and bis(isocyanato-$C_{6-10}$-aryl)-$C_{1-10}$-alkanes, preferably bis(isocyanato-$C_{6-8}$-aryl)-$C_{1-6}$-alkanes, such as tolidine diisocyanate, etc.], poly(isocyanatoaryl) ethers (e.g., di(isocyanatophenyl) ether, etc.), poly(isocyanatoaryl) sulfones (e.g., di(isocyanatophenyl) sulfone, etc.), etc.], etc.}, and aromatic polyisocyanates having three or more isocyanate groups (e.g., tri- or tetra-isocyanates such as 4,4'-diphenylmethane-2,2',5,5'-tetraisocyanate, etc.).

These polyisocyanate compounds may be used singly or in combination of two or more thereof. The polyisocyanate compound is usually composed by using at least a diisocyanate compound in many cases.

In the polyisocyanate compound, the content of the isocyanate group (-NCO) may be, for example, approximately 3 to 70% by weight, preferably 5 to 60% by weight, and more preferably 7 to 50% by weight.

In addition to the polyisocyanate compound as the main component, the polyisocyanate resin component contains a curing agent (or a crosslinking agent or a polyisocyanate curing agent) composed of an aromatic amine-based curing agent.

As the aromatic amine-based curing agents, curing agents exemplified in the section of the epoxy resin component described above may be mentioned and preferred embodiments are also the same as described above. The aromatic amine-based curing agents may be used singly or in combination of two or more thereof.

Incidentally, as long as the curing agent contains an aromatic amine-based curing agent, it may be combined with the other curing agent [e.g., non-aromatic amine curing agents (the non-aromatic amine curing agents exemplified in the section of the epoxy resin component, etc.), polyol compounds, etc.].

In the case where the aromatic amine-based curing agent is combined with the other curing agent, the ratio thereof can be selected from the range of the former/the latter (weight ratio) = approximately 99.9/0.1 to 30/70 (e.g., 99.5/0.5 to 40/60), and may be, for example, approximately 99/1 to 50/50, preferably 98/2 to 70/30, and more preferably 97/3 to 80/20.

The ratio of the curing agent (or the aromatic amine-based curing agent) depends on the type of the curing agent and the combination of the polyisocyanate compound with the curing agent, but may be, for example, relative to 100 parts by weight of the polyisocyanate compound, approximately 0.1 to 500 parts by weight, preferably 1 to 300 parts by weight and more preferably 2 to 200 parts by weight (e.g., 3 to 100 parts by weight), and may be usually approximately 4 to 80 parts by weight (e.g., 5 to 60 parts by weight).

The ratio of the conductive metal powder to the resin component having an aromatic amine skeleton (e.g., the epoxy resin component, the polyisocyanate resin component, etc.) can be selected from the range of, for example, the former/the latter (weight ratio) = approximately 99.9/0.1 to 20/80 (e.g., 99.7/0.3 to 30/70) and may be, for example, approximately 99.5/0.5 to 40/60 (e.g., 99.3/0.7 to 45/55), preferably 99/1 to 50/50 (e.g., 98.5/1.5 to 55/45), more preferably 98/2 to 60/40 (e.g., 97.5/2.5 to 60/40), and particularly 97/3 to 60/40 (e.g., 96.5/3.5 to 65/35), and may be usually 99/1 to 60/40 (e.g., 98/2 to 65/35, preferably 97/3 to 70/30, and more preferably 96/4 to 80/20). In the present invention, by combining the metal flake, the metal nanoparticle and the specific resin component, it is possible to efficiently obtain a conductive composition having excellent conductivity and close contact even when the ratio of the resin component is large.

(Other Components)

The conductive composition of the present invention may further contain a solvent (or a dispersion medium). Such a composition containing a solvent (particularly, a paste-like composition) is suitable as a coating composition (conductive composition for coating). The solvent is not particularly limited and examples thereof include water, alcohols {e.g., aliphatic alcohols [e.g., saturated or unsaturated $C_{1-30}$ aliphatic alcohols, preferably saturated or unsaturated $C_{8-24}$ aliphatic alcohols, such as methanol, ethanol, propanol, isopropanol, butanol, hexanol, heptanol, octanol (1-octanol, 2-octanol, etc.), decanol, lauryl alcohol, tetradecyl alcohol, cetyl alcohol, 2-ethyl-1-hexanol, octadecyl alcohol, hexadecenol, and oleyl alcohol, etc.], alicyclic alcohols [e.g., cycloalkanols such as cyclohexanol; terpene alcohols (e.g., monoterpene alcohol, etc.) such as terpineol and dihydroterpineol; etc.], araliphatic alcohols (e.g., benzyl alcohol, phenethyl alcohol, etc.), polyhydric alcohols (glycols such as (poly)$C_{2-4}$-alkylene glycols such as ethylene glycol, propylene glycol, diethylene glycol, dipropylene glycol, and polyethylene glycol; polyhydric alcohols having three or more hydroxyl groups, such as glycerin, etc.), etc.}, glycol ethers (e.g., (poly)alkylene glycol monoalkyl ethers such as ethylene glycol monomethyl ether (methyl cellosolve), ethylene glycol monoethyl ether (ethyl cellosolve), ethylene glycol monobutyl ether (butyl cellosolve), diethylene glycol monomethyl ether (methyl carbitol), diethylene glycol monoethyl ether (ethyl carbitol), diethylene glycol monobutyl ether (butyl carbitol), triethylene glycol monobutyl ether, propylene glycol monomethyl ether, dipropylene glycol monomethyl ether, and tripropylene glycol butyl ether; (poly)alkylene glycol monoaryl ethers such as 2-phenoxyethanol; etc.), glycol esters (e.g., (poly)alkylene glycol acetates such as carbitol acetate, etc.), glycol ether esters (e.g., (poly)alkylene glycol monoalkyl ether acetates such as ethylene glycol monoethyl ether acetate, ethylene glycol monomethyl ether acetate, and diethylene glycol monobutyl ether acetate), hydrocarbons [e.g., aliphatic hydrocarbons (e.g., saturated or unsaturated aliphatic hydrocarbons such as hexane, trimethylpentane, octane, decane, dodecane, tetradecane, octadecane, heptamethylnonane, and tetramethylpentadecane), alicyclic hydrocarbons (cyclohexane etc.), halogenated hydrocarbons (methylene chloride, chloroform, dichloroethane, etc.), aromatic hydrocarbons (e.g., toluene, xylene, etc.), etc.], esters (e.g., methyl acetate, ethyl acetate, benzyl acetate, isoborneol acetate, methyl benzoate, ethyl benzoate, etc.), amides (mono- or di-$C_{1-4}$-acylamides such as formamide, acetamide, N-methylformamide, N-methylacetamide, N,N-dimethylformamide, and N,N-dimethylacetamide, etc.), ketones (acetone, methyl ethyl ketone, methyl isobutyl ketone, etc.), ethers (diethyl ether, dipropyl ether, dioxane, tetrahydrofuran, etc.), and organic carboxylic acids (acetic acid etc.). These solvents may be used singly or in combination of two or more thereof.

Of these solvents, widely use can be made of aliphatic alcohols (e.g., alkanols such as ethyl alcohol, propyl alcohol, isopropyl alcohol, butyl alcohol, 2-ethyl-1-hexanol, octanol, and decanol; (poly)alkanediols such as ethylene glycol, diethylene glycol, propylene glycol, dipropylene glycol, and 1,4-butanediol; glycerin, etc.), alicyclic alcohols (e.g., cycloalkanols such as cyclohexanol; terpene alcohols such as terpineol and dihydroterpineol, etc.), glycol ethers [e.g., cellosolves ($C_{1-4}$-alkyl cellosolves such as methyl cellosolve, ethyl cellosolve, and butyl cellosolve) carbitols ($C_{1-4}$-alkyl carbitols such as methyl carbitol, ethyl carbitol, propyl carbitol, and butyl carbitol, etc.), etc.], and glycol ether esters [e.g., cellosolve acetates ($C_{1-4}$-alkyl cellosolve acetates such as ethyl cellosolve acetate), and carbitol acetates (e.g., $C_{1-4}$-alkyl carbitol acetates such as butyl carbitol acetate, etc.), etc.]. Such solvents are suitable because appropriate viscosity is imparted to the conductive composition (or the conductive paste) and also it is easy to homogeneously mix the metal flake, the metal nanoparticle and the epoxy resin component.

Furthermore, the conductive composition of the present invention may contain, depending on the application, conventional additives, for example, colorants (dyes, pigments, etc.), hue-improving agents, dye-fixing agents, gloss-imparting agents, metal corrosion inhibitors, stabilizers (antioxidants, ultraviolet absorbers, etc.), surfactants or dispersing agents (anionic surfactants, cationic surfactants, nonionic surfactants, amphoteric surfactants, etc.), dispersion stabilizers, thickeners or viscosity modifiers, humectants, thixotropy-imparting agents, leveling agents, defoamers, fungicides, fillers, and reactive diluents within the range where the effects of the present invention are not impaired. These additives can be used singly or in combination of two or more thereof.

Incidentally, as described above, the conductive composition of the present invention may be a conductive composition containing a solvent. In such a conductive composition (or conductive paste) containing a solvent, the concentration of solid matter may be selected from the range of approximately 10% by weight or more (e.g., 20 to 99% by weight), although it depends on the use application, and may be, for example, 20% by weight or more (e.g., 30 to 98% by weight), preferably 40% by weight or more (e.g., 50 to 97% by weight), more preferably 60% by weight or more (e.g., 70 to 95% by weight), and usually 50 to 90% by weight (e.g., 60 to 80% by weight).

The viscosity of the conductive composition (particularly, the conductive composition containing a solvent) of the present invention is not particularly limited and can be appropriately selected according to the use application but may be, for example, at 25°C, approximately 1 to 300 Pa·s (e.g., 3 to 200 Pa·s), preferably 5 to 150 Pa·s (e.g., 7 to 100 Pa·s), and more preferably 10 to 100 Pa·s. When the viscosity is too small, there is a concern of dripping at the time of application (e.g., dispensing application), and when the viscosity is too large, there is a concern that stringing occurs. The viscosity is, for example, measured under the following conditions.

Measurement equipment: rheometer
Measurement conditions: shear strength 5 (1/s), diameter 4cm, 2° cone

Incidentally, the conductive composition of the present invention can be obtained by mixing individual components without particular limitation, but typically, it may be obtained by dispersing a conductive metal powder and a metal nano-particle-containing resin component (and other component(s), as needed) in a solvent (or a dispersing medium).

[Use Applications of Conductive Composition and Molded Body]

The conductive composition (or conductive paste) of the present invention is useful for forming various molded bodies (conductive molded bodies) that require to have conductivity (or a conductive region). For example, since the conductive composition of the present invention has conductivity, it can be utilized as a composition for forming wiring and circuits (or electrodes) on a base material. In particular, since the conductive composition of the present invention can realize high conductivity and thermal conductivity and also is excellent in close contact or adhesiveness to a base material, it is suitable as a conductive adhesive.

That is, the conductive molded body of the present invention has at least a conductive region (or a conductive film) formed of the conductive composition. More specifically, in wiring or circuit applications, the conductive molded body can be utilized such a manner that the conductive region formed of the conductive composition on a base material can be utilized as wiring or circuits (or electrodes). Furthermore, in the conductive adhesive applications, the conductive molded body comprises a conjugated base material composed of two base materials and a conductive adhesive that intervenes between the base materials and bonds the two base material (direct bonding), and the conductive adhesive is formed of the conductive composition. In such a conductive molded body, the conductive composition forming the conductive region is not particularly limited as long as it is a conductive composition containing a metal flake, a metal nanoparticle, and a resin component of the present invention. The metal flake and the metal nanoparticle are the same components as in the above conductive composition, and the resin component is also the same as the above resin component (i.e., the resin component having an aromatic amine skeleton). Usually, the metal flake may be a metal flake having a crystalline structure in which a metal (or a metal crystal) grows (crystal grows) in a flaky shape (or two-dimensionally). In particular, when diffraction integrated intensity values of a (111) plane and a (200) plane in X-ray diffraction are taken as $I_{111}$ and $I_{200}$, respectively, the metal flake may be a metal flake in which a value X represented by the aforementioned equation is 25% or less (e.g., 0 to 22%), preferably 20% or less (e.g., 0 to 18%), more preferably 15% or less (e.g., 0 to 12%), and particularly 10% or less (e.g., 0 to 9%). Incidentally, whether a conductive composition for forming the conductive region is the conductive composition of the present invention or not, it is preferable that the value X represented by the aforementioned equation is 25% or less (e.g., 0 to 22%), preferably 20% or less (e.g., 0 to 18%), more preferably 15% or less (e.g., 0 to 12%), and particularly preferably 10% or less (e.g., 0 to 9%) when diffraction integrated intensity values of a (111) plane and a (200) plane in X-ray diffraction of the conductive region are taken as $I_{111}$ and $I_{200}$, respectively.

Such a molded body can be obtained by applying (or coating) the conductive composition on a base material and subjecting it to a curing treatment. Usually, the conductive composition is directly applied on the base material without forming another adhesive layer.

The base material (or substrate) is not particularly limited and may be appropriately selected depending on the use application. A material constituting the base material may be an inorganic material (inorganic raw material) or may be an organic material (organic raw material).

Examples of the inorganic material include glasses (e.g., soda glass, borosilicate glass, crown glass, barium-containing glass, strontium-containing glass, boron-containing glass, low alkali glass, alkali-free glass, transparent crystallized glass, silica glass, quartz glass, heat-resistant glass, etc.), ceramics {metal oxides (silicon oxide, quartz, alumina or aluminum oxide, zirconia, sapphire, ferrite, titania or titanium oxide, zinc oxide, niobium oxide, mullite, beryllia, etc.), metal nitrides (aluminum nitride, silicon nitride, boron nitride, carbon nitride, titanium nitride, etc.), metal carbides (silicon carbide, boron carbide, titanium carbide, tungsten carbide, etc.), metal borides (titanium boride, zirconium boride, etc.), metal complex oxides [titanate metal salts (barium titanate, strontium titanate, lead titanate, niobium titanium, calcium titanium, magnesium titanate, etc.), zirconate metal salts (barium zirconate, calcium zirconate, lead zirconate, etc.), etc.], etc.}, metals (aluminum, copper, gold, silver, etc.), and semiconductors (semiconductors formed of conductors, semiconductors, and insulators, etc.).

Examples of the organic material include polymethyl methacrylate-based resins, styrene-based resins, vinyl chloride-based resins, polyester-based resins [including polyalkylene arylate-based resins (homo- or co-polyalkylene arylates such as polyethylene terephthalate, polybutylene terephthalate, and polyethylene naphthalate, etc.), polyarylate resins, and liquid crystal polymers], polyamide-based resins, polycarbonate-based resins, polysulfone-based resins, polyethersulfone-based resins, polyimide-based resins, cellulose derivatives, and fluorocarbon resins.

Of these materials, preferred are materials having high heat resistance, for example, inorganic materials such as semiconductors, glass and metals, and plastics such as engineering plastics [e.g., aromatic polyester-based resins (polyalkylene arylate-based resins such as polyethylene naphthalate, polyarylate-based resins, etc.), polyimide-based resin, polysulfone-based resin, etc.], liquid crystal polymers, and fluorocarbon resin.

Incidentally, in the conductive adhesive applications, the two base materials may be the same or different base materials. Specific examples of the combination of the base materials can be appropriately selected depending on the use application, and there may be mentioned a combination of a base material formed of a metal and a base material formed of a metal, and a combination of a base material formed of a metal and a base material formed of a semiconductor. In the case of being used as an adhesive between metals, as long as bonding can be performed between the metals, the metal may be formed on a non-metallic base material (e.g., a semiconductor, a plastic, etc.). As more specific examples, for example, in the semiconductor field, there may be mentioned a combination in which one base material is a lead frame [e.g., a lead frame formed of a metal (copper, a copper alloy, etc.)] and another base material is a semiconductor substrate (or a semiconductor chip) [e.g., a semiconductor base material (a silicon substrate, etc.), and a semiconductor chip in which a metal film (titanium, platinum, gold, etc.) is formed on a semiconductor base material (a silicon substrate, etc.), etc.].

The surface of the base material may be subjected to a surface treatment such as an oxidation treatment [a surface oxidation treatment, e.g., a discharge treatment (a corona discharge treatment, a glow discharge, etc.), an acid treatment (a chromic acid treatment, etc.), an ultraviolet irradiation treatment, a flame treatment, etc.], and a surface roughening treatment (a solvent treatment, a sand blasting treatment, etc.).

The thickness of the base material may be appropriately selected depending on the use application, and may be, for example, approximately 0.001 to 10 mm, preferably 0.01 to 5 mm, and more preferably 0.05 to 3 mm

Examples of the coating method of the conductive composition to the base material include, for example, a flow coating method, a spin coating method, a spray coating method, a screen printing method, a flexographic printing method, a casting method, a bar coating method, a curtain coating method, a roll coating method, a gravure coating method, a dipping method, a slit method, a photolithography method, and an inkjet method. The conductive composition can be formed, depending on the use application, in part or all over the entire surface of the base material. For example, in the case of forming wiring or a circuit, the coating film of the conductive composition may be formed in a pattern shape and, in the case of the use as a conductive adhesive, a coating film of the conductive composition may be formed corresponding to the shape of the region to be bonded between the two base materials.

In the case of forming the coating film in a pattern shape, for example, coating may be performed by utilizing a screen printing method, an inkjet printing method, an intaglio printing method (e.g., a gravure printing method, etc.), an offset printing method, an intaglio offset printing method, or a flexographic printing method.

After coating, it may be air-dried or it may be dried by heating. The heating temperature can be selected depending on the type of a solvent and is, for example, approximately 50 to 200°C, preferably 80 to 180°C, and more preferably 100 to 150°C (particularly, 110 to 140°C). The heating time is, for example, approximately 1 minute to 3 hours, preferably 5 minutes to 2 hours, and more preferably 10 minutes to 1 hour.

In the film (coating film) after coating, the conductive composition is in an uncured (precursor) state and is usually subjected to a curing treatment. Usually, the curing treatment can be carried out, at least, by heating (or firing or a heat treatment).

In the curing treatment or the heat treatment, the heating temperature (heat treatment temperature) may be, for example, approximately 100 to 350°C, preferably 120 to 320°C and more preferably 150 to 300°C (e.g., 180 to 250°C). The heating time may be, depending on the heating temperature, for example, approximately 10 minutes to 5 hours, preferably 15 minutes to 3 hours, and more preferably 20 minutes to 1 hour.

The thickness of the resulting conductive region or conductive film (coating film after the curing treatment, sintered pattern) can be appropriately selected from the range of approximately 0.01 to 10,000 $\mu$m depending on the use application, and may be, for example, approximately 0.1 to 100 $\mu$m, preferably 0.1 to 50 $\mu$m, and more preferably 0.3 to 30 $\mu$m (particularly, 0.5 to 10 $\mu$m). In the present invention, a metal film of a relatively thick film, for example, having a thickness of approximately 0.3 $\mu$m or more (e.g., 0.3 to 100 $\mu$m), preferably 0.5 $\mu$m or more (e.g., 0.5 to 50 $\mu$m), and more preferably 1 $\mu$m or more (e.g., 1 to 30 $\mu$m) may be formed. Even in the case of such a thick film, a metal film having high conductivity can be formed without impairing the close contact to the base material.

EXAMPLES

The following will describe the present invention in more detail with reference to Examples. Various components used in Examples and Comparative Examples are as follows.

(Aromatic Amine Resin Component A)

An aromatic amine resin component A was prepared by mixing 1.25 parts by weight of an aromatic polyamine [manufactured by Tokyo Chemical Industry Co., Ltd., 4,4'-methylenebis(2-ethyl-6-methylaniline)] with 3.75 parts by weight of a bisphenol A propoxydiglycidyl ether (manufactured by Wako Pure Chemical Industries, Ltd., epoxy equivalent: 228 g/eq).

(Aromatic Amine Resin Component B)

An aromatic amine resin component B was prepared by mixing 1.27 parts by weight of an aromatic polyamine (manufactured by Wako Pure Chemical Industries, Ltd., 4,4'-diaminodiphenyl ether) with 3.73 parts by weight of a bisphenol A propoxydiglycidyl ether (manufactured by Wako Pure Chemical Industries, Ltd., epoxy equivalent: 228 g/eq).

(Aromatic Amine Resin Component C)

An aromatic amine resin component C was prepared by mixing 0.76 parts by weight of an aromatic polyamine [manufactured by Tokyo Chemical Industry Co., Ltd., 4,4'-methylenebis(2-ethyl-6-methylaniline)] with 4.24 parts by weight of a diglycidyl ether of dimer acid (manufactured by Mitsubishi Chemical Corporation, "jER871", epoxy equivalent: 420 g/eq).

(Aromatic Amine Resin Component D)

An aromatic amine resin component D was prepared by mixing 1.44 parts by weight of an aromatic polyamine [manufactured by Tokyo Chemical Industry Co., Ltd., 4,4'-methylenebis(2-ethyl-6-methylaniline)] with 3.56 parts by weight of a phenol novolak type epoxy resin (manufactured by Mitsubishi Chemical Corporation, "jER152", epoxy equivalent: 174 g/eq).

(Aromatic Amine Resin Component E)

An aromatic amine resin component E was prepared by mixing 0.98 parts by weight of an aromatic polyamine [manufactured by Tokyo Chemical Industry Co., Ltd., 4,4'-methylenebis(2-ethyl-6-methylaniline)] with 5.75 parts by weight (resin content: 4.02 parts by weight) of a blocked isocyanate (manufactured by Asahi Kasei Chemicals Corporation, "Duranate SBN-70D", a polyisocyanate in which 1,6-hexamethylene diisocyanate is blocked with a pyrazole derivative, resin content: 70% by weight, NCO ratio: 10.10%).

(Non-Aromatic Amine Resin Component A)

A non-aromatic amine resin component A was prepared by mixing 0.25 parts by weight of dicyandiamide [manufactured by Mitsubishi Chemical Corporation, "DICY-7"] with 4.75 parts by weight of a bisphenol A propoxydiglycidyl ether (manufactured by Wako Pure Chemical Industries, Ltd., epoxy equivalent: 228 g/eq).

(Non-Aromatic Amine Resin Component B)

A non-aromatic amine resin component B was prepared by mixing 0.39 parts by weight of an aliphatic polyamine (manufactured by Tokyo Chemical Industry Co., Ltd., triethylenetetramine) with 6.58 parts by weight (resin content: 4.61 parts by weight) of a blocked isocyanate (manufactured by Asahi Kasei Chemicals Corporation, "Duranate SBN-70D", a polyisocyanate in which 1,6-hexamethylene diisocyanate is blocked with a pyrazole derivative, resin content: 70% by weight, NCO ratio: 10.10%).

(Silver Flake A)

A silver flake A was prepared in accordance with Example 2 of Japanese Patent No. 4,144,856. The average particle diameter (D50) of the resulting silver flake A was 6.2 $\mu$m and the value of $X = [I_{200}/(I_{111}+I_{200})] \times 100$ (%) was 5.01%.

(Silver Flake B)

A silver flake B was prepared in accordance with Example 2 of Japanese Patent No. 4,399,799. The average particle diameter (D50) of the resulting silver flake A was 2.2 $\mu$m and the value of $X = [I_{200}/(I_{111}+I_{200})] \times 100$ (%) was 7.88%.

(Silver Flake C)

A commercially available silver flake (manufactured by Mitsui Mining and Smelting Co., Ltd., "Q03R flake 2", one obtained by flattening a sphere silver powder in a ball mill, the powder being prepared by liquid-phase reduction of a silver salt) was used. The average particle diameter (D50) of the silver flake C was 1.1 $\mu$m and the value of X = $[I_{200}/(I_{111}+I_{200})] \times 100$ (%) was 30.78%.

(Silver Nanoparticle a)

A commercially available silver nanoparticle (manufactured by Mitsuboshi Belting, Ltd., "MDot-SLP", a sphere silver powder prepared by liquid-phase reduction of a silver salt) was used. The average particle diameter (D50) of the silver nanoparticle a determined by the measurement on a transmission electron microscope was 63 nm and the particle diameter distribution was 1 to 200 nm.

(Silver Nanoparticle b)

A commercially available silver nanoparticle (manufactured by Mitsui Mining and Smelting Co., Ltd., "EHD", a sphere silver powder prepared by liquid-phase reduction of a silver salt) was used. The average particle diameter (D50) of the silver nanoparticle b determined by the measurement on a scanning electron microscope was 650 nm and the particle diameter distribution was 380 to 800 nm.

(Silver Nanoparticle c)

Into 1.0 L of 2,2,4-trimethylpentane were added and dissolved 2.5 g of silver nitrate, 4.9 g of octylamine and 2.0 g of linoleic acid. While stirring, thereto was added 1.0 L of a propanol solution containing 0.03M of sodium borohydride in a dropwise manner at a dripping rate of 0.1 L/hour, followed by stirring for 3 hours. The resulting black noble metal salt solution was concentrated on an evaporator and thereto was added 2.0 L of methanol to form sphere particles as a brown precipitate, and the precipitate was collected by suction filtration. A washing/collecting step of dispersing the precipitate obtained by the above operation in 2,2,4-trimethylpentane, again adding 2.0 L of methanol to remove excess protective colloid, and forming a brown precipitate was performed three times. The collected precipitate was re-dispersed in 2,2,4-trimethylpentane, filtrated, and dried to obtain a silver nanoparticle c. The nanoparticle contains 75% by weight of silver as silver, the remainder, 25% by weigh, being a protective colloid component. The average particle diameter (D50) of the silver nanoparticle c determined by measurement on a transmission electron microscope was 5 nm and the particle diameter distribution was 1 to 10 nm.

Incidentally, the following will show measurement methods or evaluation methods of various physical properties and characteristics.

(Average Particle Diameter)

The average particle diameter (D50) of the metal flakes is a volume-based median particle diameter measured by using a laser diffraction scattering particle size distribution measuring device (manufactured by Nikkiso Co., Ltd., "Micro Track").

The average particle diameter (D50) of the metal nanoparticles is a volume-based median particle diameter measured by using a transmission electron microscope. The volume conversion was performed, assuming that the particles are spherical.

(Crystallinity)

The crystallinity of the silver flakes was measured as follows.

A press ring was attached to the position approximately 2 mm lower from a sample surface of a sample holder and a silver flake powder was charged. After the sample surface was brought into close-contact to the glass plate, the press ring was pushed with a pressing jig from the opposite side and the silver flake powder was hardened so that the sample surface became flat, thereby preparing a measurement sample.

By using a X-ray diffraction apparatus (manufactured by RIGAKU, RINT1200), the measurement was performed under measurement conditions of a $2\theta/\theta$ scan method, an X-ray wavelength of CuK$\alpha$ line ($\lambda$ = 0.15418 nm), and a scanning angle of 35 to 55°, a value of $[I_{200}/(I_{111}+I_{200})] \times 100$ (%) was calculated when diffraction integrated intensity values of diffraction peaks from a (111) plane at approximately 38° and a (200) plane at approximately 44° derived from silver were taken as $I_{111}$ and $I_{200}$, respectively.

The crystallinity of conductive compositions (or cured products thereof) was measured as follows.

A conductive composition was applied onto a polytetrafluoroethylene (PTFE) plate by using an applicator and was heated at 120°C for 30 minutes and subsequently at 200°C for 90 minutes to form a film-shaped cured product having a thickness of approximately 200 to 400 $\mu$m. The film-shaped cured product was peeled from the polytetrafluoroethylene plate and XRD measurement was performed for the surface coated by using the applicator (front side) and the surface that was in contact with the PTFE plate (PTFE side). The measurement was performed under the same conditions as in the measurement of the silver flakes and a value of $[I_{200}/(I_{111}+I_{200})] \times 100$ (%) was calculated when diffraction integrated intensity values of diffraction peaks from a (111) plane at approximately 38° and a (200) plane at approximately 44° derived from silver were taken as $I_{111}$ and $I_{200}$, respectively.

(Resistivity)

A conductive composition was applied to a slide glass by using an applicator and, after dried at 120°C for 30 minutes, was dried and fired under predetermined conditions (fired at 120°C for 30 minutes without drying in Example 6 and Reference Example 4; and in the other cases, fired at 200°C for 90 minutes after dried at 120°C for 30 minutes) to form a conductive film having a thickness of 15 $\mu$m, and then resistivity was calculated from the surface resistance measured by a four-probe method and the film thickness measured by a stylus type film thickness meter.

(Peeling Test)

A conductive composition was applied to a slide glass (substrate) by using an applicator and, after dried at 120°C for 30 minutes, was dried and fired under predetermined conditions (fired at 120°C for 30 minutes without drying in Example 6 and Reference Example 4; and in the other cases, fired at 200°C for 90 minutes after dried at 120°C for 30 minutes) to form a conductive film having a thickness of 15 $\mu$m.

A cellophane tape having a width of 24 mm (manufactured by Nichiban Co., Ltd.) was attached to the conductive film formed on the glass substrate and a load of approximately 5 kgf was applied thereon. Then, the tape was rubbed with the load so that air bubbles between the conductive film and the cellophane tape disappeared, thereby removing the air bubbles to adhere the cellophane tape to the substrate. Thereafter, the cellophane tape was lifted up with fixing the substrate and was peeled off all at once at a rate of approximately 0.6 second while care was taken so that the angle between the substrate and the tape was approximately 90°. The close contact was judged to be good (A) in the case where any of the conductive film was not attached to the tape and the close contact was judged to be not good (B) in the case where a part or all of the conductive film was peeled off.

(Bond Strength)

By using a conductive composition, a silicon chip of 3.5 mm $\times$ 3.5 mm was attached to a copper plate having a thickness of 2 mm and, after drying at 120°C for 30 minutes, was fired at 200°C for 90 minutes to bond the silicon chip [a silicon chip having a film formed by sputtering titanium, platinum, and gold in this order on silicon (bonding surface being gold)] to the copper plate. Thereafter, evaluation was performed by measuring the shear strength thereof. The thickness of the bonding layer after curing was 30 $\mu$m and the number of measured samples was 4.

(Thermal Conductivity)

By using a resistivity value measured, thermal conductivity was measured by using an equation according to the Wiedemann-Franz law: $\lambda = L \times T/\rho v$ ($\lambda$ is thermal conductivity, L is Lorentz number ($2.44 \times 10^{-8}$ W·$\Omega$·K$^{-2}$), T is absolute temperature (298K), and pv is resistivity).

(Example 1)

A conductive composition was obtained by kneading 50 parts by weight of the silver flake A, 50 parts by weight of the silver nanoparticle a, 5 parts by weight of the aromatic amine resin component A, and 10 parts by weight of triethylene glycol monobutyl ether (manufactured by Wako Pure Chemical Industries, Ltd.) as a solvent by a three-roll. Then, for the resulting conductive composition, various characteristics were evaluated.

Furthermore, when X = $[I_{200}/(I_{111}+I_{200})] \times 100$ (%) of the cured product was measured, it was 4.83% on the front side and 1.65% on the PTFE side.

(Example 2)

A conductive composition was obtained in the same manner as in Example 1 except that the silver flake A was used in an amount of 75 parts by weight instead of 50 parts by weight and the silver nanoparticle a was used in an amount of 25 parts by weight instead of 50 parts by weight in Example 1. Then, for the resulting conductive composition, various characteristics were evaluated.
Furthermore, when $X = [I_{200}/(I_{111}+I_{200})] \times 100$ (%) of the cured product was measured, it was 2.72% on the front side and 3.18% on the PTFE side.

(Example 3)

A conductive composition was obtained in the same manner as in Example 1 except that 5 parts by weight of the aromatic amine resin component B was used instead of 5 parts by weight of the aromatic amine resin component A and also 10 parts by weight of a mixed solvent of pentanediol/terpineol (weight ratio = 1/2) was used instead of 10 parts by weight of triethylene glycol monobutyl ether in Example 1. Then, for the resulting conductive composition, various characteristics were evaluated.

(Example 4)

A conductive composition was obtained in the same manner as in Example 1 except that 5 parts by weight of the aromatic amine resin component C was used instead of 5 parts by weight of the aromatic amine resin component A in Example 1. Then, for the resulting conductive composition, various characteristics were evaluated.

(Example 5)

A conductive composition was obtained in the same manner as in Example 1 except that 5 parts by weight of the aromatic amine resin component D was used instead of 5 parts by weight of the aromatic amine resin component A in Example 1. Then, for the resulting conductive composition, various characteristics were evaluated.

(Example 6)

A conductive composition was obtained in the same manner as in Example 1 except that 6.73 parts by weight (resin component: 5 parts by weight) of the aromatic amine resin component E was used instead of 5 parts by weight of the aromatic amine resin component A and also 9 parts of diethylene glycol monobutyl ether (manufactured by Wako Pure Chemical Industries, Ltd.) was used instead of 10 parts of triethylene glycol monobutyl ether in Example 1. Then, for the resulting conductive composition, various characteristics were evaluated.

(Example 7).

A conductive composition was obtained in the same manner as in Example 1 except that 50 parts by weight of the silver flake B was used instead of 50 parts by weight of the silver flake A in Example 1. Then, for the resulting conductive composition, various characteristics were evaluated.
Furthermore, when $X = [I_{200}/(I_{111}+I_{200})] \times 100$ (%) of the cured product was measured, it was 3.74% on the front side and 2.25% on the PTFE side.

(Example 8)

A conductive composition was obtained in the same manner as in Example 1 except that 50 parts by weight of the silver flake C was used instead of 50 parts by weight of the silver flake A in Example 1. Then, for the resulting conductive composition, various characteristics were evaluated.
Furthermore, when $X = [I_{200}/(I_{111}+I_{200})] \times 100$ (%) of the cured product was measured, it was 32.04% on the front side and 33.52% on the PTFE side.
(Example 9) This example does not form part of the invention and is provided for information purposes only. A conductive composition was obtained in the same manner as in Example 1 except that 50 parts by weight of the silver nanoparticle b was used instead of 50 parts by weight of the silver nanoparticle a in Example 1. Then, for the resulting conductive composition, various characteristics were evaluated.

(Example 10)

A conductive composition was obtained by adding terpineol (manufactured by Wako Pure Chemical Industries, Ltd.) as a solvent to 95 parts by weight of the silver flake A, 6.67 parts by weight of the silver nanoparticle c (5 parts by weight as silver) and 5 parts by weight of the aromatic amine resin component A so that the silver concentration in the paste became 80% by weight and kneading the whole by a three-roll. Then, for the resulting conductive composition, various characteristics were evaluated.

Furthermore, when $X = [I_{200}/(I_{111}+I_{200})] \times 100$ (%) of the cured product was measured, it was 1.89% on the front side and 1.35% on the PTFE side.

(Example 11)

A conductive composition was obtained by adding terpineol (manufactured by Wako Pure Chemical Industries, Ltd.) as a solvent to 90 parts by weight of the silver flake A, 13.33 parts by weight of the silver nanoparticle c (10 parts by weight as silver) and 5 parts by weight of the aromatic amine resin component A so that the silver concentration in the paste became 80% by weight and kneading the whole by a three-roll. Then, for the resulting conductive composition, various characteristics were evaluated.

Furthermore, when $X = [I_{200}/(I_{111}+I_{200})] \times 100$ (%) of the cured product was measured, it was 2.69% on the front side and 2.44% on the PTFE side.

(Example 12)

A conductive composition was obtained in the same manner as in Example 1 except that the aromatic amine resin component A was used in an amount of 10 parts by weight instead of 5 parts by weight in Example 1. Then, for the resulting conductive composition, various characteristics were evaluated.

Furthermore, when $X = [I_{200}/(I_{111}+I_{200})] \times 100$ (%) of the cured product was measured, it was 3.21% on the front side and 1.23% on the PTFE side.

(Example 13)

A conductive composition was obtained in the same manner as in Example 10 except that the aromatic amine resin component A was used in an amount of 10 parts by weight instead of 5 parts by weight in Example 10. Then, for the resulting conductive composition, various characteristics were evaluated.

Furthermore, when $X = [I_{200}/(I_{111}+I_{200})] \times 100$ (%) of the cured product was measured, it was 2.81% on the front side and 1.36% on the PTFE side.

(Reference Example 1)

A conductive composition was obtained in the same manner as in Example 1 except that the silver flake A was not used and 100 parts by weight of the silver nanoparticle a was used instead of 50 parts by weight of the silver nanoparticle a in Example 1. Then, for the resulting conductive composition, various characteristics were evaluated.

(Reference Example 2)

A conductive composition was obtained in the same manner as in Example 1 except that the silver flake A was not used and 50 parts by weight of the silver nanoparticle a and 50 parts by weight of the silver nanoparticle b were used instead of 50 parts by weight of the silver nanoparticle a in Example 1. Then, for the resulting conductive composition, various characteristics were evaluated.

Furthermore, when $X = [I_{200}/(I_{111}+I_{200})] \times 100$ (%) of the cured product was measured, it was 33.23% on the front side and 34.21% on the PTFE side.

(Reference Example 3)

A conductive composition was obtained in the same manner as in Example 1 except that 5 parts by weight of the non-aromatic amine resin component A was used instead of 5 parts by weight of the aromatic amine resin component A in Example 1. Then, for the resulting conductive composition, various characteristics were evaluated.

(Reference Example 4)

A conductive composition was obtained in the same manner as in Example 1 except that 6.97 parts by weight (resin component: 5 parts by weight) of the non-aromatic amine resin component B was used instead of 5 parts by weight of the aromatic amine resin component A and also 10 parts of diethylene glycol monobutyl ether (manufactured by Wako Pure Chemical Industries, Ltd.) was used instead of 10 parts of triethylene glycol monobutyl ether in Example 1. Then, for the resulting conductive composition, various characteristics were evaluated.

The results are shown in Table 1. In Table 1, "amine type" means an abbreviation of "amine resin component".

[Table 1]

| | Silver flake | | | Silver nanoparticles | | Resin component | | Resistivity | Peeling test | Shear strength | Thermal conductivity |
|---|---|---|---|---|---|---|---|---|---|---|---|
| | Type | X (%) | Part by weight | Type | Part by weight | Type | Part by weight | μΩ·cm | | N | W/m·k |
| Example 1 | A | 5.01 | 50 | a | 50 | Aromatic amine type A | 5 | 5.3 | A | 117 | 137 |
| Example 2 | A | 5.01 | 75 | a | 25 | Aromatic amine type A | 5 | 8.3 | A | 105 | 88 |
| Example 3 | A | 5.01 | 50 | a | 50 | Aromatic amine type B | 5 | 5.8 | A | 91 | 125 |
| Example 4 | A | 5.01 | 50 | a | 50 | Aromatic amine type C | 5 | 5.5 | A | 93 | 132 |
| Example 5 | A | 5.01 | 50 | a | 50 | Aromatic amine type D | 5 | 5.3 | A | 93 | 137 |
| Example 6 | A | 5.01 | 50 | a | 50 | Aromatic amine type E | 5 | 24 | A | 112 | 30 |
| Example 7 | B | 7.88 | 50 | a | 50 | Aromatic amine type A | 5 | 6.4 | A | 131 | 114 |
| Example 8 | c | 30.78 | 50 | a | 50 | Aromatic amine type A | 5 | 17.0 | A | 136 | 43 |
| Example 9* | A | 5.01 | 50 | b | 50 | Aromatic amine type A | 5 | 39.9 | A | 67 | 18 |
| Example 10 | A | 5.01 | 95 | c | 5 | Aromatic amine type A | 5 | 8.4 | A | 163 | 87 |
| Example 11 | A | 5.01 | 90 | c | 10 | Aromatic amine type A | 5 | 7.5 | A | 94 | 97 |
| Example 12 | A | 5.01 | 50 | a | 50 | Aromatic amine type A | 10 | 15.9 | A | 107 | 46 |
| Example 13 | A | 5.01 | 95 | c | 5 | Aromatic amine type A | 10 | 15.8 | A | 175 | 46 |

(continued)

| | Silver flake | | | Silver nanoparticles | | Resin component | | Resistivity | Peeling test | Shear strength | Thermal conductivity |
|---|---|---|---|---|---|---|---|---|---|---|---|
| | Type | X (%) | Part by weight | Type | Part by weight | Type | Part by weight | μΩ·cm | | N | W/m·k |
| Reference Example 1 | - | - | - | a | 100 | Aromatic amine type A | 5 | 7.1 | B | 67 | 102 |
| Reference Example 2 | - | - | - | a/b (50/50) | 100 | Aromatic amine type A | 5 | 10.0 | B | 45 | 73 |
| Reference Example 3 | A | 5.01 | 50 | a | 50 | Non-aromatic amine type A | 5 | 58 | A | 47 | 13 |
| Reference Example 4 | A | 5.01 | 50 | a | 50 | Non-aromatic amine type B | 5 | 172 | A | 104 | 4 |

\* This example does not form part of the invention and is provided for information purposes only.

EP 2 902 449 B1

INDUSTRIAL APPLICABILITY

Since the conductive composition of the present invention can realize high conductivity, it can be utilized in various use applications, for example, as a composition for forming wiring, circuits, and electrodes and as a conductive adhesive. Particularly, since the conductive composition can realize high conductivity and heat radiation without impairing high close contact, it is suitable as a conductive adhesive for bonding two base materials each other.

**Claims**

1.  A conductive composition comprising a conductive metal powder and a resin component, wherein the conductive metal powder contains a metal flake and a metal nanoparticle, wherein the metal nanoparticle has an average particle diameter (D50) of 4 to 100 nm, wherein the average particle diameter (D50) of the metal nanoparticle is a volume-based median particle diameter measured by using a transmission electron microscope, and the resin component contains an aromatic amine skeleton.

2.  The conductive composition according to claim 1, wherein the metal flake has a crystalline structure in which a metal crystal grows in a flake shape.

3.  The conductive composition according to claim 1 or 2, wherein the metal flake is a metal flake in which a value X represented by the following equation is 20% or less when diffraction integrated intensity values of a (111) plane and a (200) plane in X-ray diffraction are taken as $I_{111}$ and $I_{200}$, respectively:

$$X = [I_{200}/(I_{111}+I_{200})] \times 100\ (\%)$$

wherein the value X is measured as described in the description.

4.  The conductive composition according to any one of claims 1 to 3, wherein the ratio of the metal flake to the metal nanoparticle is as follows: the former/the latter (weight ratio) = 99/1 to 30/70.

5.  The conductive composition according to any one of claims 1 to 4, wherein the resin component is a thermosetting resin component.

6.  The conductive composition according to any one of claims 1 to 5, wherein the resin component is composed of a thermosetting resin and a curing agent and the thermosetting resin and/or the curing agent are a thermosetting resin component containing an aromatic amine skeleton.

7.  The conductive composition according to claim 6, wherein the curing agent is composed of an aromatic amine-based curing agent.

8.  The conductive composition according to claim 6 or 7, wherein the resin component is an epoxy resin component containing an epoxy resin and a curing agent composed of an aromatic amine-based curing agent or a polyisocyanate resin component containing a polyisocyanate compound and a curing agent composed of an aromatic amine-based curing agent.

9.  The conductive composition according to any one of claims 6 to 8, wherein the resin component is an epoxy resin component containing an epoxy resin having an epoxy equivalent of 600 g/eq or less and a curing agent composed of an aromatic amine-based curing agent.

10. The conductive composition according to any one of claims 1 to 9, wherein the ratio of the conductive metal powder to the resin component is as follows: the former/the latter (weight ratio) = 99/1 to 50/50.

11. The conductive composition according to any one of claims 1 to 10, wherein the ratio of the metal flake to the metal nanoparticle is as follows: the former/the latter (weight ratio) = 97/3 to 35/65 and the ratio of the conductive metal powder to the resin component is as follows: the former/the latter (weight ratio) = 97/3 to 70/30.

12. The conductive composition according to any one of claims 1 to 11, which is a conductive adhesive.

13. Use of a conductive composition according to any one of claims 1 to 12, as a conductive adhesive for bonding a metal base material with a semiconductor base material.

14. A conductive molded body having at least a conductive region formed of the conductive composition described in any one of claims 1 to 12.

15. The molded body according to claim 14, which is a molded body comprising a conjugated base material composed of two base materials and a conductive adhesive that intervenes between the base materials and bonds the two base materials, wherein the conductive adhesive is the conductive region formed of the conductive composition described in any one of claims 1 to 12.

16. A conductive molded body having at least a conductive region formed of a conductive composition described in any one of claims 1 to 12, wherein a value X represented by the following equation is 20% or less when diffraction integrated intensity values of a (111) plane and a (200) plane in X-ray diffraction of the conductive region are taken as $I_{111}$ and $I_{200}$, respectively:

$$X = [I_{200}/(I_{111}+I_{200})] \times 100 \ (\%)$$

wherein the value X is measured as described in the description.

**Patentansprüche**

1. Leitfähige Zusammensetzung, umfassend ein leitfähiges Metallpulver und eine Harzkomponente, wobei das leitfähige Metallpulver Metallplättchen und Metallnanoteilchen enthält und die Metallnanoteilchen einen mittleren Teilchendurchmesser (D50) von 4 bis 100 nm aufweisen, wobei der mittlere Teilchendurchmesser (D50) der Metallnanoteilchen der Median des auf dem Volumen basierenden Teilchendurchmessers (D50) ist, der unter Verwendung eines Transmissionselektronenmikroskops gemessen wird, und die Harzkomponente ein Gerüst aus einem aromatischen Amin enthält.

2. Leitfähige Zusammensetzung gemäß Anspruch 1, wobei die Metallplättchen eine kristalline Struktur aufweisen, in der ein Metallkristall in einer Plättchenform wächst.

3. Leitfähige Zusammensetzung gemäß Anspruch 1 oder 2, wobei es sich bei den Metallplättchen um Metallplättchen handelt, in denen ein Wert X, der durch die folgende Gleichung dargestellt ist, 20% oder weniger beträgt, wenn die integrierten Beugungsintensitätswerte der (111)-Ebene und der (200)-Ebene in der Röntgenbeugung als $I_{111}$ bzw. $I_{200}$ herangezogen werden:

$$X = [I_{200}/(I_{111}+I_{200})] \times 100 (\%)$$

wobei der Wert X gemäß der Beschreibung gemessen wird.

4. Leitfähige Zusammensetzung gemäß einem der Ansprüche 1 bis 3, wobei das Verhältnis von Metallplättchen zu Metallnanoteilchen wie folgt ist:

Ersteres/Letzterem (Gewichtsverhältnis) = 99/1 bis 30/70.

5. Leitfähige Zusammensetzung gemäß einem der Ansprüche 1 bis 4, wobei die Harzkomponente eine wärmehärtende Harzkomponente ist.

6. Leitfähige Zusammensetzung gemäß einem der Ansprüche 1 bis 5, wobei sich die Harzkomponente aus einem wärmehärtenden Harz und einem Härtungsmittel zusammensetzt und das wärmehärtende Harz und/oder das Härtungsmittel wärmehärtende Harzkomponenten sind, die ein Gerüst aus einem aromatischen Amin enthalten.

7. Leitfähige Zusammensetzung gemäß Anspruch 6, wobei sich das Härtungsmittel aus einem Härtungsmittel auf Basis eines aromatischen Amins zusammensetzt.

8. Leitfähige Zusammensetzung gemäß Anspruch 6 oder 7, wobei die Harzkomponente eine Epoxidharzkomponente ist, die ein Epoxidharz und ein Härtungsmittel, das sich aus einem Härtungsmittel auf Basis eines aromatischen Amins zusammensetzt, enthält, oder eine Polyisocyanatharzkomponente ist, die eine Polyisocyanatverbindung und ein Härtungsmittel, das sich aus einem Härtungsmittel auf Basis eines aromatischen Amins zusammensetzt, enthält.

9. Leitfähige Zusammensetzung gemäß einem der Ansprüche 6 bis 8, wobei die Harzkomponente eine Epoxidharzkomponente ist, die ein Epoxidharz mit einem Epoxidäquivalent von 600 g/val oder weniger und ein Härtungsmittel, das sich aus einem Härtungsmittel auf Basis eines aromatischen Amins zusammensetzt, enthält.

10. Leitfähige Zusammensetzung gemäß einem der Ansprüche 1 bis 9, wobei das Verhältnis von leitfähigem Metallpulver zur Harzkomponente wie folgt ist:

```
Ersteres/Letzterem (Gewichtsverhältnis) = 99/1 bis 50/50.
```

11. Leitfähige Zusammensetzung gemäß einem der Ansprüche 1 bis 10, wobei das Verhältnis von Metallplättchen zu Metallnanoteilchen wie folgt ist:

```
Ersteres/Letzterem (Gewichtsverhältnis) = 97/3 bis 35/65
```

und das Verhältnis von leitfähigem Metallpulver zur Harzkomponente wie folgt ist:

```
Ersteres/Letzterem (Gewichtsverhältnis) = 97/3 bis 70/30.
```

12. Leitfähige Zusammensetzung gemäß einem der Ansprüche 1 bis 11, bei der es sich um einen leitfähigen Klebstoff handelt.

13. Verwendung der leitfähigen Zusammensetzung gemäß einem der Ansprüche 1 bis 12 als leitfähiger Klebstoff zum Verkleben eines Metallbasismaterials mit einem Halbleiterbasismaterial.

14. Leitfähiger Formkörper mit mindestens einem leitfähigen Bereich, der aus der in den Ansprüchen 1 bis 12 beschriebenen leitfähigen Zusammensetzung gebildet ist.

15. Formkörper gemäß Anspruch 14, bei dem es sich um einen Formkörper handelt, der ein konjugiertes Basismaterial aus zwei Basismaterialien und einen leitfähigen Klebstoff enthält, der zwischen den Basismaterialien wirkt und die beiden Basismaterialien verklebt, wobei der leitfähige Klebstoff der leitfähige Bereich ist, der aus der in den Ansprüchen 1 bis 12 beschriebenen leitfähigen Zusammensetzung gebildet ist.

16. Leitfähiger Formkörper mit mindestens einem leitfähigen Bereich, der aus der in den Ansprüchen 1 bis 12 beschriebenen leitfähigen Zusammensetzung gebildet ist, wobei ein Wert X, der durch die folgende Gleichung dargestellt ist, 20% oder weniger beträgt, wenn die integrierte Beugungsintensitätswerte der (111)-Ebene und der (200)-Ebene in der Röntgenbeugung als $I_{111}$ bzw. $I_{200}$ herangezogen werden:

$$X = [I_{200}/(I_{111}+I_{200})] \times 100(\%)$$

wobei der Wert X gemäß der Beschreibung gemessen wird.

**Revendications**

1. Composition conductrice comprenant une poudre de métal conducteur et un composant de résine, dans laquelle la poudre de métal conducteur contient un flocon de métal et une nanoparticule de métal, dans laquelle la nanoparticule de métal a un diamètre moyen de particules (D50) de 4 à 100 nm, dans laquelle le diamètre moyen de particules (D50) de la nanoparticule de métal est un diamètre médian de particules basé sur le volume, mesuré en utilisant un microscope électronique à transmission, et le composant de résine contient un squelette d'amine aromatique.

2. Composition conductrice selon la revendication 1, dans laquelle le flocon de métal a une structure cristalline dans laquelle un cristal de métal se développe en une forme de flocon.

3. Composition conductrice selon la revendication 1 ou 2, dans laquelle le flocon de métal est un flocon de métal dans lequel une valeur X représentée par l'équation suivante est de 20% ou moins lorsque les valeurs d'intensité de diffraction intégrées d'un plan a(111) et d'un plan a(200) en diffraction des rayons X sont prises comme $I_{111}$ et $I_{200}$, respectivement :

$$X = [I_{200}/(I_{111} + I_{200})] \times 100 \, (\%)$$

où la valeur X est mesurée comme le décrit la description.

4. Composition conductrice selon l'une quelconque des revendications 1 à 3, dans laquelle le rapport du flocon de métal à la nanoparticule de métal est le suivant:

premier/second (rapport en poids) = 99/1 à 30/70.

5. Composition conductrice selon l'une quelconque des revendications 1 à 4, dans laquelle le composant de résine est un composant de résine thermodurcissable.

6. Composition conductrice selon l'une quelconque des revendications 1 à 5, dans laquelle le composant de résine est composé d'une résine thermodurcissable et d'un agent de durcissement et la résine thermodurcissable et/ou l'agent de durcissement sont un constituant de résine thermodurcissable contenant un squelette d'amine aromatique.

7. Composition conductrice selon la revendication 6, dans laquelle l'agent de durcissement est composé d'un agent de durcissement à base d'amine aromatique.

8. Composition conductrice selon la revendication 6 ou 7, dans laquelle le composant de résine est un composant de résine époxy contenant une résine époxy et un agent de durcissement composé d'un agent de durcissement à base d'amine aromatique ou un composant de résine polyisocyanate contenant un composé polyisocyanate et un agent de durcissement composé d'un agent de durcissement à base d'amine aromatique.

9. Composition conductrice selon l'une quelconque des revendications 6 à 8, dans laquelle le composant de résine est un composant de résine époxy contenant une résine époxy ayant un équivalent époxy de 600 g/éq. ou moins et un agent de durcissement composé d'un agent de durcissement à base d'amine aromatique.

10. Composition conductrice selon l'une quelconque des revendications 1 à 9, dans laquelle le rapport de la poudre de métal conducteur au composant de résine est le suivant :

premier/second (rapport en poids) = 99/1 à 50/50.

11. Composition conductrice selon l'une quelconque des revendications 1 à 10, dans laquelle le rapport du flocon de métal à la nanoparticule de métal est le suivant: premier/second (rapport en poids) = 97/3 à 35/65 et le rapport de la poudre de métal conducteur au composant de résine est le suivant : premier/second (rapport en poids) = 97/3 à 70/30.

**12.** Composition conductrice selon l'une quelconque des revendications 1 à 11, qui est un adhésif conducteur.

**13.** Utilisation d'une composition conductrice selon l'une quelconque des revendications 1 à 12, en tant qu'adhésif conducteur pour lier un matériau de base métallique avec un matériau de base semiconducteur.

**14.** Corps moulé conducteur ayant au moins une région conductrice formée de la composition conductrice décrite dans l'une quelconque des revendications 1 à 12.

**15.** Corps moulé selon la revendication 14, qui est un corps moulé comprenant un matériau de base conjugué composé de deux matériaux de base et un adhésif conducteur qui est intercalé entre les matériaux de base et lie les deux matériaux de base, dans lequel l'adhésif conducteur est la région conductrice formée de la composition conductrice décrite dans l'une quelconque des revendications 1 à 12.

**16.** Corps moulé conducteur ayant au moins une région conductrice formée d'une composition conductrice décrite selon l'une quelconque des revendications 1 à 12, dans lequel une valeur X représentée par l'équation suivante est de 20 % ou moins lorsque les valeurs d'intensité de diffraction intégrées d'un plan a(111) et d'un plan a(200) en diffraction des rayons X de la région conductrice sont prises comme $I_{111}$ et $I_{200}$, respectivement :

$$X = [I_{200}/(I_{111} + I_{200})] \times 100 \ (\%)$$

où la valeur X est mesurée comme le décrit la description.

**REFERENCES CITED IN THE DESCRIPTION**

**Patent documents cited in the description**

- JP 2008171828 A
- JP 2012092442 A
- US 20050194577 A1
- JP 2011044509 A
- JP H11066953 B
- JP 3429985 B
- JP 4144856 B
- JP 4399799 B
- JP 2009144188 A
- JP 2005281781 A
- JP 2005298921 A
- JP 2006124787 A
- JP 2006152344 A
- JP 2007146271 A
- JP 2007321215 A
- JP 2008223101 A
- JP 2009030084 A
- JP 2009062598 A
- JP 2009074171 A
- JP 2009120940 A
- JP 2010202943 A
- JP 2010229544 A